# EUROPÄISCHE PATENTSCHRIFT

(11) **EP 3 916 219 B1**
(45) Veröffentlichungstag und Bekanntmachung des Hinweises auf die Patenterteilung: **19.06.2024**
(21) Anmeldenummer: 20176671.4
(22) Anmeldetag: 26.05.2020
(51) Int. Cl.: F03D 7/04

(54) **VERFAHREN ZUM STEUERN EINER WINDENERGIEANLAGE**
METHOD FOR CONTROLLING A WIND ENERGY SYSTEM
PROCÉDÉ DE COMMANDE D'UNE ÉOLIENNE

(43) Veröffentlichungstag der Anmeldung: 01.12.2021
(73) Patentinhaber: Wobben Properties GmbH, 26607 Aurich (DE)
(72) Erfinder: Brombach, Johannes, 13437 Berlin (DE)
(74) Vertreter: Eisenführ Speiser

(56) Entgegenhaltungen:
- WO-A1-2018/033191
- VAN DER HOEK DAAN ET AL: "Comparison of Down-Regulation Strategies for Wind Farm Control and their Effects on Fatigue Loads", 2018 ANNUAL AMERICAN CONTROL CONFERENCE (ACC), AACC, 27. Juni 2018 (2018-06-27), Seiten 3116-3121, XP033387377, DOI: 10.23919/ACC.2018.8431162 [gefunden am 2018-08-09]
- MIRZAEI MAHMOOD ET AL: "Model based active power control of a wind turbine", 2015 AMERICAN CONTROL CONFERENCE (ACC), IEEE, Seiten 5037-5042, XP032621861, ISSN: 0743-1619, DOI: 10.1109/ACC.2014.6859055 [gefunden am 2014-07-17]

## Beschreibung

Die vorliegende Erfindung betrifft ein Verfahren zum Steuern einer Windenergieanlage. Die vorliegende Erfindung betrifft auch eine Windenergieanlage.

Zum Betreiben einer Windenergieanlage wird diese üblicherweise im Teillastbetrieb, wenn die Windgeschwindigkeit also unter einer Nennwindgeschwindigkeit ist, mit einem möglichst optimalen Betriebspunkt betrieben. Bei einer Windenergieanlage mit variabler Drehzahl und einem Rotor mit in ihrem Blattwinkel verstellbaren Rotorblättern ist ein solcher Betriebspunkt durch die Drehzahl, den Blattwinkel und die resultierende Abgabeleistung gekennzeichnet. Wenn der optimale Betriebspunkt eingestellt ist, ist somit die Abgabeleistung für die dann vorherrschende Windgeschwindigkeit die maximale Leistung, die die Windenergieanlage bei der Windgeschwindigkeit dauerhaft erzeugen kann.

Zur Darstellung dieses und anderer Betriebspunkte wird häufig ein Schnelllaufzahl-Blattwinkel-Diagramm verwendet, das hier als λθ-Diagramm bezeichnet wird. In diesem λθ-Diagramm wird somit die Schnelllaufzahl λ des betreffenden Betriebspunktes bei dem entsprechenden Wert des Blattwinkels θ desselben Betriebspunktes eingetragen.

Die Schnelllaufzahl λ ist allgemein definiert als das Verhältnis der Blattspitzengeschwindigkeit des Rotorblattes zur Windgeschwindigkeit. Die resultierende Schnelllaufzahl λ ist somit einheitenlos. Durch die Betrachtung der Relation zwischen Drehzahl und Windgeschwindigkeit kann das λθ-Diagramm für unterschiedliche Windgeschwindigkeiten verwendet werden. Es können also Betriebspunkte unterschiedlicher Windgeschwindigkeiten in demselben Diagramm eingetragen werden. Im Idealfall können sogar Betriebspunkte unterschiedlicher Windgeschwindigkeiten in diesem Diagramm identisch sein.

Solche identischen Betriebspunkte können sich im Teillastbetrieb ergeben, wenn bei unterschiedlichen Windgeschwindigkeiten der Blattwinkel konstant bleibt, also nicht verändert wird, und die Drehzahl proportional zur Windgeschwindigkeit ist. Genau ein solcher Zustand wird im idealen Entwurf einer Windenergieanlage auch angestrebt. Verändern sich nämlich Drehzahl und Windgeschwindigkeit proportional zueinander, so bleibt der Anströmwinkel, mit dem die Luft tatsächlich das Rotorblatt anströmt, gleich. Es ist daher auch sinnvoll, den Blattwinkel ebenfalls unverändert zu lassen.

Die Abgabeleistung bleibt hierbei natürlich nicht gleich, denn mit zunehmender Windgeschwindigkeit und zunehmender Drehzahl kann auch mehr Leistung erzeugt werden.

Zusätzlich ist es üblich und sinnvoll, in dem λθ-Diagramm Leistungsbeiwerte, die auch als Cp-Werte bezeichnet werden, einzuzeichnen. Ein solcher Leistungsbeiwert gibt somit die Effizienz an, mit der der entsprechende Betriebspunkt Windleistung in Rotationsleistung umsetzen kann. Betriebspunkte mit gleichem Cp-Wert werden zur besseren Darstellung auf einer gemeinsamen Linie gezeichnet, die jeweils eine geschlossene Linie ist. Beispielsweise können solche Cp-Kennlinien in Schritten von 0,05 eingezeichnet werden. Diese Kennlinien werden hier auch als Iso-Kennlinien bezeichnet. Bei optimaler Auslegung der Windenergieanlage liegt ihr Betriebspunkt im Teillastbetrieb beim höchstmöglichen Cp-Wert, der etwas größer als 0,45 ist.

Die Festlegung eines Betriebspunktes ist somit vergleichsweise eindeutig, nämlich möglichst so, dass die Leistungsausbeute möglichst hoch ist, was häufig zu einem Betriebspunkt führt, der innerhalb der Iso-Kennlinie liegt, die den höchsten Cp-Wert aufweist. Je nach Randbedingungen kann es aber sein, dass Betriebspunkte nicht diesen Idealwert erreichen können. Insbesondere bei sehr geringen Windgeschwindigkeiten können beispielsweise Reibungszustände so dominant sein, dass ein Betriebspunkt mit vergleichsweise hoher Drehzahl, also einer höheren Schnelllaufzahl, zu wählen ist, der dann auch einen erhöhten Blattwinkel aufweisen kann. Auch die Maximaldrehzahl einer Windenergieanlage ist begrenzt. So darf ab einer bestimmten Windgeschwindigkeit die Drehzahl der Anlage nicht weiter steigen und es kommt zu Betriebspunkten außerhalb des Optimums.

Aber auch solche Betriebszustände können durch Simulationen oder gegebenenfalls Anpassungen vor Ort bestimmt werden.

Es kommt nun in Betracht, dass zusätzliche Anforderungen zu erfüllen sind, die eine reduzierte Abgabeleistung vorgeben. Beispielsweise kann für einen Zeitraum, der beispielsweise 15 Minuten betragen kann, aber auch mehrere Stunden dauern kann, eine reduzierte Abgabeleistung gefordert werden, um damit einer Situation des elektrischen Versorgungsnetzes gerecht zu werden. Eine solche Situation kann bei einem entsprechend geringen Bedarf an Leistung auftreten, sie kann aber auch gefordert werden, um eine Vorhalteleistung bereitzustellen. Beim Bereitstellen einer Vorhalteleistung wird die Windenergieanlage mit einer geringeren Abgabeleistung betrieben als aufgrund des vorherrschenden Windes möglich ist, sodass sie bei einem plötzlichen Anstieg des Leistungsbedarfs ihre Leistungsproduktion dann erhöhen kann, nämlich dauerhaft erhöhen kann auf die maximal aus dem vorherrschenden Wind erzeugbare Leistung. Es kommen aber auch andere Vorgaben in Betracht, wie beispielsweise die Vorgabe, dass die Windenergieanlage zur Geräuschminimierung reduziert zu betreiben ist. Die Reduzierung kann hierbei eine Abgabeleistung, aber auch eine Drehzahl betreffen.

Liegt nun eine Anforderung für eine Leistungsreduzierung vor, gibt es viele Möglichkeiten, einen entsprechenden Betriebspunkt zu wählen. Jedenfalls wird nicht mehr der optimale Betriebspunkt gewählt, also der Betriebspunkt bei maximalem Cp-Wert, denn der würde zur maximalen Leistung führen, die aber nicht gewünscht ist. Der Betriebspunkt mit reduzierter Leistung kann beispielsweise so gewählt werden, dass die reduzierte Abgabeleistung bei möglichst geringem Verschleiß erzeugt wird. Der Betriebspunkt kann auch so gewählt werden, dass er besonders stabil ist, geringe Änderungen der Windgeschwindigkeit also nicht zu einem Stall-Effekt führen, also zu einem aerodynamischen Kollaps.

Aber auch der Wunsch, einen Betriebspunkt mit möglichst geringem Verschleiß zu wählen, kann zu verschiedenen Varianten führen. So kann ein geringer Verschleiß vorliegen, wenn die Drehzahl der Windenergieanlage möglichst gering ist. Das kann aber dazu führen, dass bei Windgeschwindigkeitsänderungen die Rotorblätter in ihrem Anstellwinkel häufig nachgestellt werden müssen, sodass dieser Betriebspunkt dann hinsichtlich der Verstellantriebe der Rotorblätter nicht verschleißarm ist. Möglicherweise kann hier ein Gütekriterium definiert werden, das solche verschiedenen Anforderungen mit aufnimmt.

Nun können weitere Situationen auftreten, bei denen die Windenergieanlage aus einem reduzierten Betriebspunkt möglichst schnell einen weniger reduzierten Betriebspunkt ansteuern muss. Eine solche Anforderung kann sich auch aus Gegebenheiten des elektrischen Versorgungsnetzes ergeben, besonders eine schnelle Frequenzänderung der Netzfrequenz des elektrischen Versorgungsnetzes kann einen solchen Bedarf auslösen. Besonders wenn die Netzfrequenz des elektrischen Versorgungsnetzes unter einen Grenzwert abfällt, der beispielsweise 0,3 % unterhalb der Netznennfrequenz liegen kann, kann es erforderlich sein, dass die reduziert betriebene Windenergieanlage ihre Abgabeleistung schnell erhöht, nämlich besonders mit weiter abfallender Netzfrequenz.

Daraus ergibt sich dann das Problem, für diese neue Situation einen Betriebspunkt zu finden. Dabei kann es auch wichtig sein, den Übergang von dem reduzierten Betriebspunkt zu dem weniger - oder gegebenenfalls auch gar nicht mehr - reduzierten Betriebspunkt zu finden.

In Van der Hoek Daan et al., "Comparison of Down-Regulation Strategies for Wind Farm Control and their Effects on Fatigue Loads", Annual American Control Conference, 27. Juni 2018, Seiten 3116-3121 werden drei Abregelungsstrategien für Windenergieanlagen vorgestellt. In einer von drei Strategien wird die Schnelllaufzahl zum Drosseln erhöht.

Der vorliegenden Erfindung liegt somit die Aufgabe zugrunde, wenigstens eins der vorgenannten Probleme zu adressieren. Insbesondere soll eine Lösung gefunden werden, mit der ein reduzierter Betriebspunkt vorgegeben wird. Insbesondere soll dieser reduzierte Betriebspunkt auch im Hinblick auf eine weitere Veränderung zu einem weniger reduzierten Betriebspunkt möglichst vorteilhaft gewählt werden. Insbesondere soll auch für die Wahl eines solchen weniger reduzierten Betriebspunktes ein Vorschlag angegeben werden. Zumindest soll zu bisher bekannten Lösungen eine Alternative vorgeschlagen werden.

Erfindungsgemäß wird ein Verfahren zum Steuern einer Windenergieanlage nach Anspruch 1 vorgeschlagen. Es wird somit von einer Windenergieanlage ausgegangen, die einen Rotor mit in ihrem Blattwinkel verstellbaren Rotorblättern aufweist und wobei der Rotor mit einer variablen Drehzahl betreibbar ist. Insoweit kann von einer üblichen Windenergieanlage ausgegangen werden.

Das Verfahren betrifft den Fall, bei dem die Windenergieanlage in einem Teillastbereich betrieben wird. Der Teillastbereich ist dadurch gekennzeichnet, dass nicht ausreichend Wind vorhanden ist, um die Windenergieanlage mit Nennleistung zu betreiben. Damit liegt auch die Windgeschwindigkeit unter einer Nennwindgeschwindigkeit. Häufig liegt dabei die Drehzahl der Windenergieanlage auch unterhalb einer Nenndrehzahl.

Die Windenergieanlage ist in einem veränderlich vorgebbaren Betriebspunkt betreibbar und dieser Betriebspunkt ist durch den Blattwinkel, also den Wert des Blattwinkels, und eine Schnelllaufzahl gekennzeichnet. Dieser Betriebspunkt kann in einem λθ-Diagramm dargestellt werden. Ein solches λθ-Diagramm, das synonym auch als Schnelllaufzahl-Blattwinkel-Diagramm bezeichnet werden kann, ist oben einleitend bereits beschrieben worden. In einem solchen λθ-Diagramm ist die Schnelllaufzahl über dem Blattwinkel aufgetragen und der Betriebspunkt ist dann in dem λθ-Diagramm als Wertepaar aus seinem Blattwinkel und seiner Schnelllaufzahl darstellbar.

Der Betriebspunkt kann also durch ein Wertepaar (θ, λ) dargestellt werden, indem θ den Blattwinkel bzw. den Wert des Blattwinkels und λ die Schnelllaufzahl bezeichnet. Weiterhin ist, wie einleitend auch schon beschrieben wurde, jedem Betriebspunkt ein Leistungsbeiwert, der auch als Cp-Wert bezeichnet werden kann, zugeordnet. Mehrere Betriebspunkte mit gleichem Cp-Wert sind als Iso-Kennlinie in dem λθ-Diagramm darstellbar. Eine solche Iso-Kennlinie ist somit aus vielen Betriebspunkten mit gleichem Cp-Wert zusammengesetzt, wobei dies fiktive Betriebspunkte sein können, es müssen also nicht Betriebspunkte sein, die in der konkreten Steuerung der betreffenden Windenergieanlage auch vorgesehen sind. Diese Iso-Kennlinien dienen dazu, die Aerodynamik der Windenergieanlage zu charakterisieren. Die Iso-Kennlinien können auch synonym als Kennlinien gleichen Cp-Wertes oder als Kennlinien gleichen Leistungsbeiwertes bezeichnet werden.

Gemäß einem Schritt wird die Windenergieanlage in einem Normalbetriebspunkt betrieben, wenn keine Anforderung einer Drosselung vorliegt. Ein solcher Normalbetriebspunkt ist dadurch gekennzeichnet, dass die Windenergieanlage nicht gedrosselt betrieben wird. Der Normalfall ist somit, dass die Windenergieanlage in einem Normalbetriebspunkt betrieben wird. Es kann aber natürlich auch sein, dass, je nach Windenergieanlage, ständig eine Anforderung einer Drosselung vorliegt. Aber selbst in diesem Fall ist grundsätzlich ein Normalbetriebspunkt vorgesehen, in dem die Windenergieanlage auch betrieben werden würde, wenn keine Anforderung einer Drosselung vorliegt.

Außerdem wird die Windenergieanlage in einem Drosselbetriebspunkt betrieben, bei dem die Windenergieanlage auf eine Drosselanforderung hin mit gegenüber dem Normalbetriebspunkt gedrosselter Abgabeleistung betrieben wird. Im Drosselbetriebspunkt ist die Windenergieanlage also gegenüber dem Normalbetriebspunkt gedrosselt, nämlich in ihrer Abgabeleistung. Die Anlage gibt also weniger Leistung ab bzw. erzeugt auch weniger Leistung aus dem Wind als im Normalbetriebspunkt. Gleichwohl muss die Windenergieanlage aber betrieben werden; wenn sie also angehalten ist, ist sie zwar gewissermaßen auch gedrosselt, es liegt aber kein Betreiben der Windenergieanlage in diesem Sinne mehr vor.

Weiterhin ist das Wechseln des Betriebs der Windenergieanlage aus dem Drosselbetriebspunkt in einen Reservebetriebspunkt vorgesehen. In dem Reservebetriebspunkt wird die Windenergieanlage gegenüber dem Drosselbetriebspunkt mit erhöhter Abgabeleistung betrieben. Der Wechsel von dem Drosselbetriebspunkt in den Reservebetriebspunkt erfolgt als Reaktion auf eine Leistungserhöhungsanforderung. Die Windenergieanlage gibt somit in dem Reservebetriebspunkt mehr Leistung ab, wird also mit einer höheren Abgabeleistung betrieben, als im Drosselbetriebspunkt. Der Reservebetriebspunkt liegt somit veranschaulichend zwischen dem Drosselbetriebspunkt und dem Normalbetriebspunkt. Es kommt aber grundsätzlich auch in Betracht, dass in dem Reservebetriebspunkt ebenso viel Leistung abgegeben wird wie im Normalbetriebspunkt. In diesem Fall können der Normalbetriebspunkt und der Reservebetriebspunkt dennoch verschieden sein, zum Beispiel eine unterschiedliche Schnelllaufzahl aufweisen. Vorzugsweise wird im Reservebetriebspunkt aber weniger Leistung abgegeben als im Normalbetriebspunkt.

Es wird nun vorgeschlagen, dass der Drosselbetriebspunkt so gewählt wird, dass er gegenüber dem Reservebetriebspunkt eine erhöhte Schnelllaufzahl aufweist. Grundsätzlich wird davon ausgegangen, dass die jeweils verglichenen Betriebspunkte, also der Normalbetriebspunkt, der Drosselbetriebspunkt und der Reservebetriebspunkt, bei gleicher Windgeschwindigkeit betrieben werden. Natürlich kann sich die Windgeschwindigkeit ändern und besonders bei einer anhaltenden Drosselsituation, bei der die Windenergieanlage also für einen längeren Zeitraum in dem Drosselbetriebspunkt betrieben wird, ist auch davon auszugehen, dass sich die Windgeschwindigkeit zumindest geringfügig ändert. Für die vergleichende Beschreibung ist dennoch davon auszugehen, dass die jeweils zugrundeliegende Windgeschwindigkeit gleich ist, denn, erhöht sich die Windgeschwindigkeit und verändert sich dadurch der Drosselbetriebspunkt, so ist dieser erhöhten Windgeschwindigkeit auch ein veränderter Normalbetriebspunkt und auch ein veränderter Reservebetriebspunkt zuzuordnen, ob sie in dem Moment nun angesteuert werden oder nicht. Somit beziehen sich also die Vergleiche immer auf eine Situation, bei der den drei genannten Betriebspunkten dieselbe Windgeschwindigkeit zugrunde liegt.

Davon abgesehen wird ein Wechsel besonders vom Drosselbetriebspunkt zum Reservebetriebspunkt so schnell durchgeführt werden, dass auch tatsächlich von einer näherungsweise unveränderten Windgeschwindigkeit während dieses Wechselvorgangs ausgegangen werden kann.

Zur Wahl des Drosselbetriebspunktes wird somit vorgeschlagen, dass er gegenüber dem Reservebetriebspunkt eine erhöhte Schnelllaufzahl aufweist. Zusätzlich wird für die Wahl des Drosselbetriebspunktes vorgeschlagen, dass er in dem λθ-Diagramm auf einer zugehörigen Iso-Kennlinie liegt und die zugehörige Iso-Kennlinie in dem Drosselbetriebspunkt eine negative Kennliniensteigung aufweist, bei der die Schnelllaufzahl mit steigendem Blattwinkel abnimmt. Die zugehörige Iso-Kennlinie ist somit diejenige, die auch den Drosselbetriebspunkt beinhaltet. Wie schon erläutert, sind solche Iso-Kennlinien geschlossene Kennlinien, was in der Natur der Sache liegt, solange sie nicht den Darstellungsbereich des Diagramms verlassen. Diese Kennlinien bzw. die jeweils betrachtete Iso-Kennlinie weist somit Abschnitte auf, die eine negative Steigung haben, und welche, die eine positive Steigung haben. An zwei Stellen ist die Steigung auch null. Besonders weist jede Iso-Kennlinie grundsätzlich zwei Bereiche mit negativer Steigung auf. Ein Bereich davon dürfte grundsätzlich eine geringere Schnelllaufzahl aufweisen als der Normalbetriebspunkt und dieser Bereich kommt für den vorgeschlagenen Drosselbetriebspunkt nicht in Betracht. Der andere Bereich, der hier nämlich vorgeschlagen wird, liegt in dem λθ-Diagramm im Wesentlichen "rechts oben" in Bezug auf den optimalen Betriebspunkt, der dem Normalbetriebspunkt entspricht. In dem vorgeschlagenen Bereich, in dem der Drosselbetriebspunkt zu wählen ist, sind also die Schnelllaufzahl und der Blattwinkel überwiegend größer als die Schnelllaufzahl und der Blattwinkel des Normalbetriebspunktes.

Der vorgeschlagene Bereich bezieht sich aber auf den Reservebetriebspunkt und diesem gegenüber ist die Schnelllaufzahl größer zu wählen und die Iso-Kennlinie hat eine negative Kennliniensteigung aufzuweisen.

Hier wurde besonders erkannt, dass durch die vorgeschlagene Wahl der Drosselbetriebspunkt gegenüber dem Reservebetriebspunkt eine erhöhte Drehzahl aufweist. Ist nun die Abgabeleistung als Reaktion auf die Leistungserhöhungsanforderung zu erhöhen, insbesondere nämlich schnell zu erhöhen, so ist die vorgeschlagene Wahl des Drosselbetriebspunktes vorteilhaft. Zum Wechsel muss nämlich die Drehzahl des Drosselbetriebspunktes reduziert werden, um den Reservebetriebspunkt erreichen zu können. Dadurch muss mehr Leistung abgegeben werden und diese steht somit unmittelbar und sofort bereit, sobald diese Drehzahlreduzierung durchgeführt wird. Besonders kann sogar die Drehzahlreduzierung durch die Erhöhung der Abgabeleistung ausgelöst werden.

Es wurde zudem erkannt, dass beim Betreiben der Windenergieanlage im Teillastbereich häufig noch Potential zur Drehzahlerhöhung ist, ohne an technische Grenzen zu stoßen. Besonders wurde erkannt, dass die Nenndrehzahl noch nicht erreicht ist und insoweit ohne Gefährdung der Windenergieanlage eine Drehzahlerhöhung möglich ist. Es wurde aber auch erkannt, dass je nach vorherrschender Windgeschwindigkeit die Drehzahl nur wenig unter der Nenndrehzahl liegen kann, ein geringes Potential zur Erhöhung der Drehzahl gleichwohl noch gegeben ist. Durch eine Veränderung des Betriebspunktes in dem Bereich, in dem die Iso-Kennlinien eine negative Kennliniensteigung aufweisen, besonders, wenn diese Steigung dem Betrage nach wenigstens 1/1° beträgt, kann eine signifikante Reduzierung des Leistungsbeiwertes erreicht werden. Dadurch kann man zu einem Betriebspunkt mit weniger Abgabenleistung gelangen, während sich die Drehzahl erhöht und Leistung aufnimmt, wobei die dabei durchgeführte Drehzahlerhöhung aber vergleichsweise gering sein kann, während gleichzeitig aber auch die Veränderung des Blattwinkels vergleichsweise gering ist. Der Drosselbetriebspunkt kann also leicht erreicht werden und insbesondere kann von ihm schnell zum Reservebetriebspunkt zurückgewechselt werden.

Gleichzeitig wurde aber erkannt, dass allein die Wahl einer höheren Drehzahl nicht unbedingt zu einem vorteilhaften Wechsel führt, zumindest nicht zu einem optimalen Wechsel führen muss. Besonders wurde erkannt, dass der Drosselbetriebspunkt auch gegenüber dem Reservebetriebspunkt einen schlechteren Leistungsbeiwert, also einen geringeren Cp-Wert, aufweisen muss, denn das ist Voraussetzung, damit weniger Abgabeleistung abgegeben wird. Das kann durch Verstellung der Rotorblätter erreicht werden. Um von dem Drosselbetriebspunkt dann zum Reservebetriebspunkt bei dem genannten Wechsel zurückzukommen, müssen auch die Rotorblätter wieder zurückgedreht werden. Dabei wurde erkannt, dass das Verstellen der Rotorblätter eine gewisse Mindestzeit erfordert, nämlich bedingt durch die Dynamik der Verstellantriebe. Dazu wurde weiter erkannt, dass in den Bereichen, in denen die Iso-Kennlinien eine negative Steigung aufweisen, die Iso-Kennlinien auch vergleichsweise nah beieinander liegen. Das bedeutet, dass eine vergleichsweise starke Veränderung des Cp-Wertes mit einer vergleichsweise geringen Verstellung der Rotorblätter erreicht werden kann.

Somit wird für den Drosselbetriebspunkt vorgeschlagen, dass dieser in Bezug auf den Reservebetriebspunkt so gewählt wird, dass er mit möglichst wenig Blattverstellung zu dem Reservebetriebspunkt überführt werden kann, während gleichzeitig die Rotordrehzahl bei diesem Wechsel verringert wird und dadurch kinetische Energie in Leistung umgesetzt werden kann. Der Wechsel erfolgt also möglichst schnell und ermöglicht zugleich, dass bereits zu Beginn des Wechsels die erhöhte Abgabeleistung, nämlich gemäß dem angestrebten Reservebetriebspunkt, abgegeben und eingespeist werden kann.

Erfindungsgemäß wird vorgeschlagen, dass die Kennliniensteigung im Drosselbetriebspunkt mit einem Wert abnimmt, der dem Betrage nach wenigstens 0,5/1° beträgt. Es wurde erkannt, dass somit eine signifikant negative Steigung zu besonders dicht aneinanderliegenden Iso-Kennlinien gehört und somit dort besonders schnell der Cp-Wert verändert werden kann, also eine hohe Veränderung des Cp-Wertes bei möglichst geringer Veränderung der Blattwinkel. Besonders bei Schnellaufzahlen, die größer sind als die Schnelllaufzahl des Normalbetriebspunktes tritt dieser Effekt ein. Somit wird auch als zusätzliche Bedingung vorgeschlagen, dass der Drosselbetriebspunkt eine Schnelllaufzahl aufweist, die größer ist als die Schnelllaufzahl des Normalbetriebspunktes.

Gemäß einer Ausgestaltung wird vorgeschlagen, dass der Reservebetriebspunkt gegenüber dem Normalbetriebspunkt mit geringerer Abgabeleistung betrieben wird. Im Reservebetriebspunkt gibt die Windenergieanlage also weniger Leistung ab als im Normalbetriebspunkt. Weiterhin ist aber die Abgabeleistung des Drosselbetriebspunktes geringer als im Reservebetriebspunkt. Der Reservebetriebspunkt liegt somit hinsichtlich der Höhe der Abgabeleistung zwischen dem Drosselbetriebspunkt und dem Normalbetriebspunkt. Wenn der Betrieb der Windenergieanlage aus dem Drosselbetriebspunkt in den Reservebetriebspunkt wechselt, wird somit die Abgabeleistung erhöht, aber nicht bis auf den Wert des Normalbetriebspunktes.

Außerdem oder alternativ wird vorgeschlagen, dass der Reservebetriebspunkt gegenüber dem Drosselbetriebspunkt eine reduzierte Schnelllaufzahl aufweist. Im Reservebetriebspunkt dreht die Windenergieanlage also langsamer als im Drosselbetriebspunkt. Somit kann erreicht werden, dass zur Erhöhung der Abgabeleistung vom Drosselbetriebspunkt zum Reservebetriebspunkt anfänglich Leistung durch das Abbremsen der Windenergieanlage gewonnen werden kann.

Optional ist vorgesehen, dass der Reservebetriebspunkt gegenüber dem Normalbetriebspunkt eine erhöhte Schnelllaufzahl aufweist. In dem Fall liegt somit die Schnelllaufzahl des Reservebetriebspunktes unter der des Drosselbetriebspunktes, aber über der des Normalbetriebspunktes. Entsprechend liegt auch seine Drehzahl unter der des Drosselbetriebspunktes und oberhalb der des Normalbetriebspunktes.

Auch hier wurde erkannt, dass die Rückkehr vom Drosselbetriebspunkt zum Reservebetriebspunkt durch die erhöhte Anfangsdrehzahl erleichtert werden kann. Weiterhin wurde erkannt, dass in diesem Sinne auch ein weiterer Wechsel vom Reservebetriebspunkt zum Normalbetriebspunkt unter Zuhilfenahme kinetischer Energie möglich wäre.

Gemäß einer weiteren Ausgestaltung wird vorgeschlagen, dass der Drosselbetriebspunkt und/oder der Reservebetriebspunkt in Abhängigkeit von einem Abstand zweier Iso-Kennlinien beim Drosselbetriebspunkt bzw. beim Reservebetriebspunkt oder in Abhängigkeit von einem Gradienten des Leistungsbeiwertes des Drosselbetriebspunktes bzw. des Reservebetriebspunktes ausgewählt wird.

Jede Iso-Kennlinie steht für einen Leistungsbeiwert. Je näher zwei Iso-Kennlinien beieinander sind, umso stärker ändert sich der Leistungsbeiwert bei ansonsten gleicher Veränderung eines Betriebspunktes in dem λθ-Diagramm. Eine geringe Veränderung des Blattwinkelwertes und/oder des Wertes der Schnelllaufzahl eines Betriebspunktes in dem λθ-Diagramm führt somit bei einem geringen Abstand zweier Iso-Kennlinien in diesem Bereich zu einer schnellen Veränderung des Leistungsbeiwertes. Daher wurde erkannt, dass der Drosselbetriebspunkt und der Reservebetriebspunkt besonders dort nahe beieinanderliegen können, wo auch der Abstand zweier Iso-Kennlinien gering ist.

Entsprechend wird vorgeschlagen, den Drosselbetriebspunkt und den Reservebetriebspunkt in Abhängigkeit von einem Abstand zweier Iso-Kennlinien zu wählen. Es kann aber auch ausreichen, wenn nur einer dieser beiden Betriebspunkte in Abhängigkeit von einem Abstand zweier Iso-Kennlinien gewählt wird.

Alternativ kann einer der beiden Betriebspunkte oder beide Betriebspunkte in Abhängigkeit von einem Gradienten des Leistungsbeiwertes des Drosselbetriebspunktes bzw. des Reservebetriebspunktes ausgewählt werden. Je höher der Gradient des Leistungsbeiwertes dem Betrage nach ist, also je größer die Steigung des Leistungsbeiwertes des betreffenden Betriebspunktes ist, umso enger können der Drosselbetriebspunkt und der Reservebetriebspunkt beieinanderliegen. Insoweit kann der Gradient des Leistungsbeiwertes des Drosselbetriebspunktes betrachtet werden, um den Drosselbetriebspunkt zu wählen bzw. der Gradient des Leistungsbeiwertes des Reservebetriebspunktes betrachtet werden, um den Reservebetriebspunkt zu wählen. Insbesondere wird vorgeschlagen, den Drosselbetriebspunkt und/oder den Reservebetriebspunkt dort zu wählen, wo der Gradient des Leistungsbeiwertes dem Betrage nach besonders groß ist.

Als Gradient des Leistungsbeiwertes kann vorzugsweise eine Ableitung des Leistungsbeiwertes ausschließlich nach dem Blattwinkel gewählt werden. Hier wurde besonders erkannt, dass eine betragsmäßig große Ableitung des Leistungsbeiwertes nach dem Blattwinkel einen Bereich kennzeichnet, in dem mit geringer Veränderung der Blattwinkel große Veränderungen des Leistungsbeiwertes erreicht werden können und damit große Unterschiede der entsprechenden Abgabeleistungen der betreffenden Betriebspunkte resultieren.

Es kann aber auch ein Gradient gewählt werden, der nach dem Blattwinkel und auch nach der Schnelllaufzahl abgeleitet wird. Für eine vergleichbare Dimension zwischen Blattwinkel und Schnelllaufzahl kann es sinnvoll sein, den Blattwinkel hierbei auf einen ganzen Winkelgrad zu normieren. In der Darstellung des λθ-Diagramms entspräche dann die Länge eines Grads Blattwinkelverstellung der Länge einer Veränderung der Schnelllaufzahl um den Wert 1.

Gemäß einer Ausführungsform wird vorgeschlagen, dass der Drosselbetriebspunkt und/oder der Reservebetriebspunkt so gewählt werden, dass jeweils eine Ableitung des Leistungsbeiwertes des Drosselbetriebspunktes bzw. des Reservebetriebspunktes nach dem Blattwinkel dem Betrage nach einen vorbestimmten Mindestableitungswert überschreitet. Somit wird hier die Ableitung des Leistungsbeiwertes nach dem Blattwinkel betrachtet. Je größer diese Ableitung dem Betrage nach ist, umso stärker ändert sich somit der Leistungsbeiwert mit Veränderung des Blattwinkels. Dadurch kann mit geringer Veränderung des Blattwinkels eine große Änderung des Leistungsbeiwertes erreicht werden, wenn diese Ableitung entsprechend groß gewählt wird. Daher wird für den Betrag der Ableitung ein vorbestimmter Mindestableitungswert zugrunde gelegt. Damit kann auch ein quantitatives Maß vorgegeben werden.

Es ist besonders damit zu rechnen, dass der Leistungsbeiwert mit zunehmendem Blattwinkel abnimmt. Das liegt besonders auch darin begründet, dass häufig ein Blattwinkel von 0° oder wenigen Grad für einen leistungsoptimalen Betriebspunkt zugrunde gelegt wird. Für den Drosselbetriebspunkt und gegebenenfalls auch für den Reservebetriebspunkt ist aber eine verringerte Leistungsproduktion vorgesehen. Die Abgabeleistung ist also geringer, während der Blattwinkel erhöht ist. Daher wird der Betrag der Ableitung betrachtet, denn ihr absoluter Wert dürfte negativ sein.

Auch hier liegt wieder der Gedanke zugrunde, dass bei einer betragsmäßig großen Ableitung des Leistungsbeiwertes eine große Leistungsveränderung durch nur geringe Veränderung des Anstellwinkels erreicht werden kann. Das kann sowohl für den Drosselbetriebspunkt als auch für den Reservebetriebspunkt vorteilhaft sein. Besonders wird es gemäß einer Ausführungsform für beide Betriebspunkte vorgeschlagen und dadurch wird erreicht, dass besonders der Wechsel vom Drosselbetriebspunkt zum Reservebetriebspunkt vergleichsweise schnell durchgeführt werden kann. Die Dauer für die Veränderung zwischen diesen beiden Betriebspunkten, also besonders die Dauer für den Wechsel von dem Drosselbetriebspunkt zum Reservebetriebspunkt, kann besonders durch die Zeitdauer bestimmt werden, die für die notwendige Verstellung des Blattwinkels benötigt wird.

Vorzugsweise beträgt für den Drosselbetriebspunkt der Mindestableitungswert wenigstens 0,05/1 °. Hier wurde besonders erkannt, dass der Leistungsbeiwert von einem physikalischen Maximum etwas über 0,45 logischerweise maximal auf null reduziert werden kann. Die Veränderung des Leistungsbeiwertes um einen Wert von 0,3 ist somit eine erhebliche Leistungsreduzierung bzw. erhebliche Reduzierung des Leistungsbeiwertes. Dazu wird vorgeschlagen, dass dafür das Rotorblatt maximal um einen Wert von 6° verstellt werden soll, um eine solche Veränderung des Leistungsbeiwertes zu erreichen. Dadurch ergibt sich der vorgeschlagene Mindestableitungswert, nämlich durch die Berechnung: 0,3/6° = 0,05/1°. Das bedeutet, dass das Rotorblatt maximal um 6° zu verstellen ist, um eine Veränderung des Leistungsbeiwertes um den Wert 0,3 zu erreichen.

Außerdem oder alternativ wird vorgeschlagen, dass der Mindestableitungswert für den Reservebetriebspunkt wenigstens 0,1/6° beträgt. Hier wurde erkannt, dass für den Reservebetriebspunkt zwar auch eine große Ableitung des Leistungsbeiwertes nach dem Blattwinkel sinnvoll sein kann, dass sie gleichwohl bei dem Reservebetriebspunkt dem Betrage nach etwas geringer als bei dem Drosselbetriebspunkt ausfallen kann. Hier liegt besonders die Erkenntnis zugrunde, dass der Reservebetriebspunkt einen höheren Leistungsbeiwert aufweist als der Drosselbetriebspunkt. Der Reservebetriebspunkt ist damit bezogen auf den Leistungsbeiwert näher an dem optimalen Betriebspunkt bzw. dem Normalbetriebspunkt. Dabei wurde auch erkannt, dass es besonders wichtig sein kann, ausgehend von dem Drosselbetriebspunkt auf eine Leistungserhöhungsanforderung hin schnell die Leistung zu ändern. Damit muss die Veränderung im Drosselbetriebspunkt vorzugsweise dynamischer sein als beim Reservebetriebspunkt.

Gemäß einer Ausführungsform ist das Verfahren dadurch gekennzeichnet, dass die Windenergieanlage durch ein Kennlinienfeld aus Iso-Kennlinien in dem λθ-Diagramm charakterisiert werden kann. Es liegen also viele Iso-Kennlinien vor, von denen jede jeweils einem Leistungsbeiwert, also einem Cp-Wert, zugeordnet ist. Insoweit wird die Windenergieanlage durch ein solches Kennlinienfeld in dem λθ-Diagramm in gewohnter Weise beschrieben, zumindest in der Art und Weise, die oben bereits erläutert wurde.

Weiter wird vorgeschlagen, dass das Kennlinienfeld als normiertes Kennlinienfeld definiert werden kann, in dem der Blattwinkel auf ganze Grad (°) normiert wird. Dadurch kann ein Gradient in dem Kennlinienfeld definiert werden, der nicht von der Wahl der physikalischen Einheit abhängt. Somit wird bspw. eine Veränderung der Schnelllaufzahl um den Wert 1 einer Veränderung des Blattwinkels um 1° der Größe nach gleich gesetzt, was als sachgerecht erkannt wurde.

In dem normierten Kennlinienfeld ist ein erster Teilbereich ausgebildet, in dem die Blattwinkel größer sind als der Blattwinkel des Normalbetriebspunktes, und die Iso-Kennlinien eine negative Kennliniensteigung aufweisen, bei der die Schnelllaufzahl mit steigendem Blattwinkel abnimmt. Es wird somit nur dieser Bereich betrachtet, der anschaulich gesprochen, in dem Kennlinienfeld oben rechts liegt, wenn an der Abszisse die Blattwinkel mit steigendem Wert abgetragen sind und an der Ordinate die Schnelllaufzahlen mit steigendem Wert abgetragen sind.

Es gilt, dass in dem normierten Kennlinienfeld jeder Betriebspunkt durch einen Gradientenwert gekennzeichnet ist, der die maximale Steigung des Leistungsbeiwertes des Betriebspunktes in dem normierten Kennlinienfeld quantifiziert. Insoweit wird hier eine übliche Definition eines Gradienten zu Grunde gelegt. Der Gradient beschreibt somit, in welche Richtung sich der Leistungsbeiwert jeweils am stärksten ändert. Das kann in Richtung des Blattwinkels, in Richtung der Schnelllaufzahl, insbesondere aber in eine Richtung sein, die sich aus diesen beiden Richtungen zusammen setzt. Die Richtung wird damit durch die maximale Steigung definiert. Der zugehörige Wert der Steigung ist der Gradientenwert. Die Gradientenrichtung wird hier ansonsten nicht weiter verwendet und wird nur dafür benötigt, den maximalen Gradientenwert eindeutig zu definieren.

In diesem ersten Teilbereich des normierten Kennlinienfeldes ist zu jeder Iso-Kennlinie ein Betriebspunkt mit maximalem Gradienten vorhanden. All diese Betriebspunkte, von denen also zu jeder Iso-Kennlinie einer gefunden werden kann, können mit einer Kennlinie verbunden werden und diese Kennlinie wird hier als Gradientenkennlinie bezeichnet. Somit ist eine Gradientenkennlinie darstellbar, die all diese Betriebspunkte mit maximalem Gradientenwert in dem betrachteten positiven Teilbereich verbindet.

Es wird nun vorgeschlagen, dass der Drosselbetriebspunkt und/oder der Reservebetriebspunkt so gewählt werden, dass sie jeweils auf dieser Gradientenkennlinie liegen. Auch hier liegt wieder der Gedanke zugrunde, dass der Drosselbetriebspunkt und/oder der Reservebetriebspunkt im Bereich einer dem Betrage nach möglichst großen Ableitung des Leistungsbeiwertes liegt, um dadurch eine schnelle und starke Leistungsveränderung bei möglichst geringer Blattwinkelveränderung erreichen zu können. Dazu wurde auch erkannt, dass diese maximale Steigung in Bezug auf den Blattwinkel und die Schnelllaufzahl in dem betrachteten ersten Teilbereich besonders den Bereich kennzeichnet, in dem eine geringe Änderung des Blattwinkels zu einer großen Änderung des Leistungsbeiwertes führt. Die Leistungsänderung kann also durch eine geringe Blattverstellung erreicht werden und kann damit schnell erreicht werden.

Es wird also vorgeschlagen, diese Gradientenkennlinie zu definieren, denn dort ist die Ableitung des Leistungsbeiwertes nach dem Blattwinkel am größten. Durch die Definition bzw. Einzeichnung dieser Gradientenkennlinie kann dieser Bereich gut verdeutlicht werden. Werden sowohl der Drosselbetriebspunkt als auch der Reservebetriebspunkt so gewählt, dass sie auf dieser Gradientenkennlinie liegen, so kann vorzugsweise der Wechsel von dem Drosselbetriebspunkt zu dem Reservebetriebspunkt entlang dieser Gradientenkennlinie vorgenommen werden. Zumindest bezogen auf die Blattverstellung ist das eine optimierte Lösung für einen möglichst schnellen Wechsel zwischen Drosselbetriebspunkt und Reservebetriebspunkt.

Wenn für die Wahl des Drosselbetriebspunktes und/oder des Reservebetriebspunktes nicht genau die Gradientenkennlinie gewählt wird, mag die gefundene Lösung nicht mehr optimal sein, sie kann gleichwohl eine gute Lösung sein und daher wird vorgeschlagen, zumindest gemäß einer Ausführungsform, den Drosselbetriebspunkt und/oder den Reservebetriebspunkt zumindest in einem die Gradientenkennlinie einschließenden Gradientenband zu wählen. Dadurch ist es auch möglich, weitere Randbedingungen berücksichtigen zu können, weil durch die Wahl eines Betriebspunktes in dem Band statt auf einer Kennlinie ein Freiheitsgrad für Veränderungen entsteht.

So können beispielsweise Überlegungen zum Verschleiß der Windenergieanlage als Randbedingung betrachtet werden. Auch Adaptionen können dadurch umgesetzt werden. Insbesondere kommt es vor, dass das Kennlinienfeld leichten Veränderungen unterworfen ist, weil es sich beispielsweise durch Verschmutzungen auf den Rotorblättern leicht verändern kann. Durch eine entsprechende Wahl in dem Gradientenband kann eine solche Randbedingung und/oder eine solche Variation auf einfache Art und Weise berücksichtigt werden, während gleichzeitig der Gedanke beibehalten wird, den Drosselbetriebspunkt und/oder den Reservebetriebspunkt zumindest in der Nähe der Gradientenkennlinie zu wählen, um dort durch eine geringe Veränderung des Blattwinkels eine große Veränderung des Leistungsbeiwertes zu erreichen.

Ein solches Gradientenband weist eine obere Bandgrenze auf, die um eine Schnelllaufzahldifferenz oberhalb der Gradientenkennlinie liegt. Außerdem weist das Gradientenband eine untere Bandgrenze auf, die um eine untere Schnelllaufzahldifferenz unterhalb der Gradientenkennlinie liegt. Es wird somit vorgeschlagen, das Gradientenband dadurch zu bilden, dass die Gradientenkennlinie in Richtung der Schnelllaufzahl um einen Wert nach oben verschoben wird, um die obere Bandgrenze zu bilden, und um einen gleichen oder anderen Wert in Bezug auf die Schnelllaufzahl nach unten verschoben wird, um die untere Bandgrenze zu bilden.

Vorzugsweise weisen die obere und die untere Schnelllaufzahldifferenz jeweils maximal den Wert 2 auf. Weist also die Gradientenkennlinie an einer Stelle für die Schnelllaufzahl den Wert 9 auf, so kann hier das Gradientenband im Bereich zwischen den Werten 7 und 11 für die Schnelllaufzahl liegen. Die obere und untere Schnelllaufzahldifferenz können aber auch unterschiedliche Werte aufweisen.

Zu dem Vorschlag, jeweils maximal den Wert 2 zu wählen, insbesondere maximal den Wert 1 zu wählen, wurde erkannt, dass eine Veränderung der Schnelllaufzahl um den Bereich des Wertes 2 im Bereich der Gradientenkennlinie nur zu moderaten Veränderungen der Ableitung des Leistungsbeiwertes nach dem Blattwinkel führt. Somit kann eine Veränderung von maximal dem Wert +2 oder -2 der Schnelllaufzahl noch den Charakter des Kennlinienfeldes bewahren, dass die Ableitung des Leistungsbeiwertes nach dem Blattwinkel noch als hoch angesehen werden kann. Bei noch größeren Werten als dem Wert 2 können die Veränderungen des jeweiligen Betriebspunktes in dem Kennlinienfeld zu deutlichen Veränderungen des Charakters des Kennlinienfeldes führen, sodass bei entsprechend größeren Werten der Veränderung der Schnelllaufzahl von einem Bereich außerhalb des Gradientenbandes ausgegangen wird.

Alternativ wird vorgeschlagen, dass die obere Schnelllaufzahldifferenz maximal den Wert 1 aufweist und die untere Schnelllaufzahldifferenz maximal den Wert 4 aufweist. Hier werden die Bandgrenzen somit unterschiedlich gewählt. Es wurde erkannt, dass besonders eine zu hohe Drehzahl und damit zu hohe Schnelllaufzahl zu vermeiden ist, um einen instabilen Betriebspunkt zu vermeiden, so dass der Abstand für die obere Bandgrenze schmal gewählt wird. Für eine geringere Drehzahl existiert dieses Problem nicht, jedenfalls erst für sehr viel größere Drehzahlabweichungen, so dass hier eine Bandbreite von 4 als sinnvoll erkannt wurde.

Gemäß einer Ausgestaltung wird vorgeschlagen, dass die Windenergieanlage in dem Drosselbetriebspunkt eine erste Abgabeleistung, eine erste Rotationsenergie und einen ersten Blattwinkel aufweist, und dass sie in dem Reservebetriebspunkt eine zweite Abgabeleistung, eine zweite Rotationsenergie und einen zweiten Blattwinkel aufweist. Die erste Abgabeleistung ist kleiner als die zweite Abgabeleistung und eine Differenz zwischen der zweiten Abgabeleistung und der ersten Abgabeleistung bildet eine Differenzabgabeleistung der Betriebspunkte. Außerdem ist die erste Rotationsenergie größer als die zweite Rotationsenergie und eine Differenz zwischen der ersten und zweiten Rotationsenergie bildet eine Differenzrotationsenergie. Diese Eigenschaften der Betriebspunkte bzw. die Eigenschaften der Windenergieanlage in diesen Betriebspunkten liegt der weiteren Betrachtung zugrunde, besonders für die Wahl zumindest eines der Betriebspunkte.

Weiterhin wird berücksichtigt, dass zum Verstellen der Rotorblätter vom ersten Blattwinkel in den zweiten Blattwinkel eine Blattverstellzeit benötigt wird. Diese Blattverstellzeit hängt von der Verstellgeschwindigkeit der Rotorblätter der Windenergieanlage ab und sie hängt auch davon ab, um welchen Wert die Blattwinkel sich zwischen dem Drosselbetriebspunkt und dem Reservebetriebspunkt unterscheiden, um welchen Wert die Blätter also verdreht werden müssen.

Ein Produkt der Differenzabgabeleistung und der Blattverstellzeit multipliziert mit 50 % bildet eine charakteristische Differenzenergie. Die Hälfte des Produktes der Differenzabgabeleistung mit der Blattverstellzeit ist also diese charakteristische Differenzenergie. Diese charakteristische Differenzenergie, die hier auch einfach als Differenzenergie bezeichnet werden kann, ist zunächst eine Begriffsdefinition. Sie hat aber auch die folgende physikalische Bedeutung.

Wird die Windenergieanlage von dem Drosselbetriebspunkt in den Reservebetriebspunkt verstellt, wobei die vorstehend genannten Annahmen bzw. Definitionen zugrunde liegen, erhöht sich die Abgabeleistung. Im Idealfall erhöht sie sich linear mit der Zeit, nämlich besonders dann, wenn die Rotorblätter gleichförmig verstellt werden und auch proportional zur Verstellung der Rotorblätter die Abgabeleistung erhöht wird. Bezogen auf den Startwert, also die Abgabeleistung des Drosselbetriebspunktes, liegt die Abgabeleistung im Übergangsbereich um einen Differenzwert oberhalb der Abgabeleistung des Drosselbetriebspunktes und dieser Differenzwert nimmt im genannten Idealfall linear mit der Zeit zu, bis die Abgabeleistung des Reservebetriebspunktes erreicht wird. Wird dieser Differenzwert der Abgabeleistung über diese Zeit aufintegriert, ergibt sich die charakteristische Differenzenergie. Wird also von einem linearen Anstieg ausgegangen, ist die Differenzenergie die Integration der Differenz der Abgabeleistung über die Zeit, in der von dem Drosselbetriebspunkt in den Reservebetriebspunkt gewechselt wird.

Basierend auf dieser Erkenntnis wird nun vorgeschlagen, dass der Drosselbetriebspunkt und/oder der Reservebetriebspunkt so gewählt werden, dass die Differenzrotationsenergie der charakteristischen Differenzenergie entspricht.

Der Drosselbetriebspunkt und/oder der Reservebetriebspunkt werden also so gewählt, dass sie unterschiedliche Drehzahlen aufweisen und diese dabei in Bezug aufeinander so gewählt werden, dass sich eine Differenzrotationsenergie einstellt. Diese Differenzrotationsenergie orientiert sich an der charakteristischen Differenzenergie, also die Energie, die den Übergang vom Drosselbetriebspunkt zum Reservebetriebspunkt charakterisiert.

Bei dieser Wahl liegt der Gedanke zugrunde, dass als Reaktion auf die Leistungserhöhungsanforderung idealerweise diese Leistungserhöhung sofort bereitgestellt wird. Idealerweise sollte die vollständig erhöhte Leistung also nicht erst vorliegen, wenn der Reservebetriebspunkt erreicht ist. Dementsprechend wird vorgeschlagen, dass diese Betriebspunkte so gewählt werden, dass aus der Differenzrotationsenergie für diesen Übergangszeitpunkt sofort die erhöhte Leistung bereitgestellt werden kann. Besonders kann aus der Rotationsenergie zu Beginn des Wechsels die gesamte Leistungsdifferenz bereitgestellt werden. Während des Übergangs vom Drosselbetriebspunkt zum Reservebetriebspunkt erhöht sich aber auch allmählich die Leistung, die aus dem Wind erzeugt wird und damit geht der Anteil der Rotationsenergie, der zum Bereitstellen der Differenzleistung benötigt wird, allmählich gegen null, bis der Reservebetriebspunkt erreicht ist.

Um dies zu erreichen, kann der Drosselbetriebspunkt so eingestellt werden, dass sich die Differenzrotationsenergie in Bezug auf einen gegebenen Reservebetriebspunkt einstellt, oder es kann der Reservebetriebspunkt so eingestellt werden, dass sich die Differenzrotationsenergie in Bezug auf den gegebenen Drosselbetriebspunkt einstellt. Es können aber auch beide Betriebspunkte gemeinsam verstellt bzw. so gewählt werden, dass sich die Differenzrotationsenergie einstellt.

Dabei kommt auch in Betracht, dass die beiden Betriebspunkte, bzw. der eine von den beiden, der verstellt wird, in einem iterativen Verfahren gefunden werden. Besonders wurde erkannt, dass nicht nur die Betriebspunkte so zu wählen sind, dass die Differenzrotationsenergie einen bestimmten Wert erreicht, sondern dass auch die dafür maßgebliche charakteristische Differenzenergie von der Blattverstellzeit abhängt und damit auch von den gewählten Betriebspunkten abhängt.

Es wurde aber auch erkannt, dass der Übergang vom Drosselbetriebspunkt zum Reservebetriebspunkt möglicherweise nicht ideal linear verläuft. Entsprechend wird vorgeschlagen, dass der Drosselbetriebspunkt und/oder der Reservebetriebspunkt so gewählt werden, dass die Differenzrotationsenergie maximal um einen vorbestimmten prozentualen Abweichungswert oberhalb oder unterhalb der charakteristischen Differenzenergie liegt. Vorzugsweise wird vorgeschlagen, dass der prozentuale Abweichungswert maximal 60 % beträgt, vorzugsweise maximal 40 % beträgt, insbesondere maximal 20 % beträgt. Damit kann berücksichtigt werden, dass der Verlauf nicht ideal linear ist. Außerdem kann im Falle eines iterativen Verfahrens auch früher abgebrochen werden, wenn beispielsweise eine Abweichung von 20 % zugelassen wird.

Es wird aber vorgeschlagen, dass der prozentuale Abweichungswert maximal 60 % betragen soll. Dadurch wird erreicht, dass die Wahl der Betriebspunkte bzw. zumindest eines der Betriebspunkte sich an der Differenzrotationsenergie orientiert und auch an der charakteristischen Differenzenergie, sodass der beschriebene Effekt ausgenutzt werden kann, ohne dass aber eine zu starke Abweichung auch zu einem Betriebspunkt führt, der besonders eine unnötig hohe oder unnötig geringe Drehzahl aufweist.

Vorzugsweise kann dafür eine Abweichung von 40 % ausreichend sein. Das wird besonders dann vorgeschlagen, wenn die Randbedingungen vergleichsweise gut bekannt sind, insbesondere die Leistungsveränderungen im Übergangsbereich vom Drosselbetriebspunkt zum Reservebetriebspunkt. Bei besonders guter Kenntnis dieser Übergänge und damit auch besonders guter Kenntnis des Kennlinienfeldes und zudem, wenn ein lineares oder nahezu lineares Verhalten im Übergangsbereich angenommen werden darf, sind 20 % als maximale Abweichung vorteilhaft.

Gemäß einer Ausführungsform wird vorgeschlagen, dass zum Einstellen des Drosselbetriebspunktes, insbesondere ausgehend von dem Normalbetriebspunkt, zunächst in einem ersten Verstellschritt ein Zwischenbetriebspunkt eingestellt wird, wobei der Zwischenbetriebspunkt denselben Cp-Wert wie der Drosselbetriebspunkt aufweist, zumindest einen um weniger als 20 % veränderten Cp-Wert aufweist. Somit wird ausgehend von dem Normalbetriebspunkt oder einem anderen Startpunkt, von dem aus die Drosselanforderung umgesetzt werden soll, der Drosselbetriebspunkt nicht unmittelbar, also auf dem direktesten Wege angesteuert. Stattdessen wird zunächst ein Zwischenbetriebspunkt gewählt, der bereits denselben Cp-Wert wie der schließlich anzusteuernde Drosselbetriebspunkt aufweist. Von dort aus wird dann, bei Beibehaltung des Cp-Wertes, der Betriebspunkt von dem Zwischenbetriebspunkt zum Drosselbetriebspunkt verändert.

Besonders wurde hier erkannt, dass durch eine Veränderung des Betriebspunktes zum Zwischenbetriebspunkt die Leistungsreduzierung umgesetzt werden kann. Hierbei kann bspw. ohne Verstellung der Blattwinkel ein Betriebspunkt mit geringer Drehzahl gefunden werden. Ein solcher Betriebspunkt kann auch zu weniger Verschleiß aufgrund der geringeren Drehzahl führen. Ein solcher Betriebspunkt kann bspw. dadurch eingestellt werden, dass ausgehend von dem Normalbetriebspunkt die Abgabeleistung zunächst etwas erhöht wird, z.B. um wenige Prozent, oder nur um ein Prozent. Diese Leistung liegt dann minimal über der in dem Moment maximal aus dem Wind erzeugbaren Leistung. Das führt dazu, dass die Drehzahl abfällt. Damit verändert sich der Betriebspunkt und verlässt den optimalen Bereich. Damit verschlechtert sich der Leistungsbeiwert und der Betriebspunkt wandert dadurch zu dem Zwischenbetriebspunkt.

Der Zwischenbetriebspunkt eignet sich aber nicht sehr gut dazu, auf eine Leistungserhöhungsanforderung die Leistung schnell wieder zu erhöhen. Besonders wenn die Drehzahl des Zwischenbetriebspunktes gering ist, steht keine oder wenig Schwungenergie zur Verfügung, um die Leistung kurzfristig und temporär dadurch zu erhöhen.

Es wurde aber erkannt, dass eine solche Leistungserhöhungsanforderung nicht sofort nach einem Wechsel in den Zwischenbetriebspunkt zu erwarten ist. Insbesondere wird vorgeschlagen, dass der Zwischenbetriebspunkt nur dann angesteuert wird, wenn bekannt ist, oder zu erwarten ist, dass eine Leistungserhöhungsanforderung nicht auftritt. Das ist besonders dann bekannt bzw. zu erwarten, wenn der Netzbetreiber das elektrische Versorgungsnetz in einem Modus betreibt, in dem eine Leistungserhöhungsanforderung nicht vorgesehen ist. Besonders kann die Leistungserhöhungsanforderung so ausgebildet sein, dass die Windenergieanlage auf einen Frequenzabfall reagieren muss. Das kann auch als Frequenzregelmodus bezeichnet werden, oder als Modus mit P(f)-Regelung. Ein solcher Modus kann aber vom Netzbetreiber ausgeschlossen oder temporär ausgeschaltet sein.

Dann kann die Windenergieanlage in den Zwischenbetriebspunkt wechseln und ggf. auch länger in diesem Zwischenbetriebspunkt betrieben werden, nämlich solange, wie der Frequenzregelmodus nicht aktiv ist.

Gleichzeitig ist aber vorgesehen, dass der Zwischenbetriebspunkt denselben Cp-Wert wie der Drosselbetriebspunkt aufweist. Es wurde nämlich erkannt, dass hinsichtlich anderer Bedingungen, insbesondere Randbedingungen, der zunächst angesteuerte Betriebspunkt mit reduzierter Abgabeleistung nicht optimal sein muss. Besonders wenn der Betriebspunkt auf eine Leistungserhöhungsanforderung reagieren können soll, weil z.B. der Frequenzregelmodus aktiv ist oder bald aktiviert wird, kann es besser sein, den Drosselbetriebspunkt zu wählen.

Daher wird vorgeschlagen, dass zunächst der Zwischenbetriebspunkt angesteuert wird und von dem aus dann, bei Beibehaltung des Cp-Wertes, der Drosselbetriebspunkt angesteuert wird bzw. in den Drosselbetriebspunkt gewechselt wird. Dabei kann der Zwischenbetriebspunkt auch zunächst für einen längeren Zeitraum beibehalten werden.

Insbesondere wird vorgeschlagen, dass in einem zweiten Verstellschritt von dem Zwischenbetriebspunkt in den Drosselbetriebspunkt gewechselt wird und das Wechseln in dem λθ-Diagramm im Wesentlichen als Veränderung entlang einer Iso-Kennlinie darstellbar ist. Beim Wechsel vom Zwischenbetriebspunkt in den Drosselbetriebspunkt wird also der Cp-Wert unverändert gelassen, zumindest allenfalls mit einer maximalen Abweichung von 20 % des Cp-Wertes der Iso-Kennlinie des Drosselbetriebspunktes verändert. Insoweit können geringe Veränderungen des Cp-Wertes, die hier auf 20 % begrenzt sind, hinnehmbar sein und besonders dafür verwendet werden, geringe Abweichungen zu kompensieren, die beispielsweise durch veränderte Aerodynamik der Rotorblätter durch Verschmutzung gegeben sein könnten.

Gemäß einer Ausgestaltung wird vorgeschlagen, dass die Drosselanforderung zum Anfordern des Betriebs der Windenergieanlage im Drosselbetriebspunkt als externe Vorgabe ausgebildet ist, die über eine Datenschnittstelle empfangen wird, und/oder dass die Leistungserhöhungsanforderung zum Anfordern des Betriebs der Windenergieanlage in dem Reservebetriebspunkt als Vorschrift zur Reaktion auf einen von der Windenergieanlage erfassten Zustand des elektrischen Versorgungsnetzes ausgebildet ist. Insbesondere ist die Leistungserhöhungsanforderung als Vorschrift ausgebildet, eine Leistungserhöhung ausgehend von dem Drosselbetriebspunkt in Abhängigkeit von einer erfassten Netzfrequenz des elektrischen Versorgungsnetzes durchzuführen.

Hier wurde besonders erkannt, dass zwei gänzlich unterschiedliche Anforderungen vorliegen können und daran sind die beiden Betriebspunkte angepasst.

Der Drosselbetriebspunkt wird somit gewählt, wenn eine externe Vorgabe vorliegt, die auch über eine Datenschnittstelle empfangen werden kann. Das impliziert bereits, dass die Drosselanforderung eher vergleichsweise langfristig ist. Beispielsweise kann eine solche Drosselanforderung eine sein, bei der der Netzbetreiber eine Reduzierung der Abgabeleistung für einen Zeitraum von 15 Minuten oder länger anfordert. Der Drosselbetriebspunkt wird dann angesteuert und die Windenergieanlage in diesem längerfristig betrieben.

Die Leistungserhöhungsanforderung ist insoweit eher eine schnelle Anforderung. Hier liegt eine Vorschrift vor, auf einen Zustand des elektrischen Versorgungsnetzes zu reagieren. Besonders ein Frequenzabfall kann somit zu der Leistungserhöhungsanforderung führen. Beispielsweise kann das Abfallen der Netzfrequenz unter eine erste untere Frequenzgrenze dazu führen, dass die Windenergieanlage innerhalb von weniger als 40 ms ihre Leistung erhöhen muss. Eine solch kurzfristige Anforderung lässt häufig die Übertragung und entsprechende Verarbeitung eines entsprechenden Anforderungssignals gar nicht zu. Dabei ist zu beachten, dass, wollte man ein solches Signal von extern übertragen, an der entsprechenden externen Stelle zusätzlich schließlich auch erst dieses Frequenzereignis erfasst werden müsste.

Stattdessen ist die Windenergieanlage dazu vorbereitet, so schnell wie möglich auf ein solches Frequenzereignis zu reagieren. Hier kann eine Trennung im elektrischen Versorgungsnetz vorliegen, über die eine Leistungszufuhr abgetrennt wurde. Das kann auch eine Abtrennung eines einspeisenden Kraftwerks bedeuten. Es gibt dann spontan ein Leistungsdefizit im elektrischen Versorgungsnetz und darauf reagiert das Netz sofort mit einem Frequenzabfall und die Windenergieanlage kann ihrerseits diesen Frequenzabfall erkennen und muss ebenfalls sofort reagieren und die Leistung erhöhen.

Hier wurde besonders erkannt, dass der Drosselbetriebspunkt und der Reservebetriebspunkt in vorteilhafter Weise auf diese beiden unterschiedlichen Anforderungsarten abgestimmt sein sollen. Besonders ist der Drosselbetriebspunkt insofern als längerfristiger Betriebspunkt ausgelegt. Der Reservebetriebspunkt kann als kurzfristiger Betriebspunkt ausgelegt sein und insbesondere sind der Drosselbetriebspunkt und/oder der Reservebetriebspunkt so zu wählen, dass ein Wechsel vom Drosselbetriebspunkt zum Reservebetriebspunkt schnell erfolgen kann, insbesondere dass so schnell wie möglich die Leistung auf diese Leistungserhöhungsanforderung erhöht wird.

Zudem sind auch entsprechende Überwachungskriterien einzurichten, nämlich für den Drosselbetriebspunkt die Auswertung entsprechender von extern zu empfangender Signale, und für den Reservebetriebspunkt eine entsprechend dauerhafte Überwachung der Netzfrequenz, oder gegebenenfalls anderer Zustandsgröße des elektrischen Versorgungsnetzes. Eine solche Zustandsgröße des elektrischen Versorgungsnetzes kann insbesondere auch zusätzlich zu der genannten Variante der Frequenzveränderung, ein Phasensprung und/oder eine Veränderung der Netzspannung in ihrer Spannungsamplitude sein. Gemäß einer Ausführungsform wird vorgeschlagen, dass die Windenergieanlage für einen längeren Zeitraum in dem Drosselbetriebspunkt betrieben wird als in dem Reservebetriebspunkt. Insbesondere ist vorgesehen, dass sie wenigstens 20-mal so lange in dem Drosselbetriebspunkt betrieben wird wie in dem Reservebetriebspunkt.

Hier wurde erkannt, dass der Drosselbetriebspunkt für eine längere Leistungsreduzierung vorgesehen ist. Besonders ist er an einen Fall angepasst, bei dem eine Drosselanforderung eine Leistungsreduzierung für wenigstens eine Viertelstunde fordert, insbesondere aber für einen noch deutlich längeren Zeitraum. Der Drosselbetriebspunkt ist also längerfristig einzustellen und dafür auszulegen. Das schließt nicht aus, dass beispielsweise bereits nach einer Minute plötzlich eine Leistungserhöhungsanforderung auftritt; diese führt aber zu einer sehr kurzfristigen Leistungserhöhung. Danach kann der Betriebspunkt wieder zurück in den Drosselbetriebspunkt wechseln.

Der Reservebetriebspunkt ist hingegen für eine kurzzeitige und kurzfristige Leistungsstützung vorgesehen. Besonders auf einen Frequenzabfall soll dieser möglichst schnell zu einer Leistungserhöhung führen. Er ist somit vorzugsweise die Reaktion auf einen Vorfall im elektrischen Versorgungsnetz, der auch als Fehler bezeichnet werden kann. Solche Fehler können häufig innerhalb von wenigen Sekunden wieder behoben sein und für diesen Zeitpunkt soll der Reservebetriebspunkt eine Stützung vorsehen. Sollte dieser Fehler jedoch dennoch etwas länger anhalten, so kann natürlich der Reservebetriebspunkt auch entsprechend länger beibehalten werden.

Erfindungsgemäß wird zudem eine Windenergieanlage nach Anspruch 10 vorgeschlagen. Diese hat
- einen Rotor mit in ihrem Blattwinkel (Θ) verstellbaren Rotorblättern, wobei der Rotor mit einer variablen Drehzahl betreibbar ist, und wobei
- die Windenergieanlage in einem Teillastbereich betreibbar ist, in dem nicht ausreichend Wind vorhanden ist, um die Windenergieanlage mit Nennleistung zu betreiben,
- die Windenergieanlage in einem veränderlich vorgebbaren Betriebspunkt betreibbar ist, und
- der Betriebspunkt durch den Blattwinkel (Θ) und eine Schnelllaufzahl (λ) gekennzeichnet ist, und wobei
- der Betriebspunkt in einem λθ-Diagramm darstellbar ist, wobei
   - in dem λθ-Diagramm die Schnelllaufzahl (λ) über dem Blattwinkel (Θ) aufgetragen ist, und
   - der Betriebspunkt in dem λθ-Diagramm als Wertepaar aus seinem Blattwinkel (Θ) und seiner Schnelllaufzahl (λ) darstellbar ist, wobei
   - jedem Betriebspunkt ein Leistungsbeiwert (Cp-Wert) zugeordnet ist, und
   - mehrere Betriebspunkte mit gleichem Cp-Wert als Iso-Kennlinie in dem λθ-Diagramm darstellbar sind,
   und die Windenergieanlage weist eine Steuerungseinrichtung auf, dazu vorbereitet, die Windenergieanlage im Teillastbereich zu betreiben, und dabei vorbereitet
- zum Betreiben der Windenergieanlage in einem Normalbetriebspunkt, bei dem die Windenergieanlage nicht gedrosselt betrieben wird, wenn keine Anforderung einer Drosselung vorliegt,
- zum Betreiben der Windenergieanlage in einem Drosselbetriebspunkt, bei dem die Windenergieanlage auf eine Drosselanforderung hin mit gegenüber dem Normalbetriebspunkt gedrosselter Abgabeleistung betrieben wird, und
- zum Wechseln des Betriebs der Windenergieanlage aus dem Drosselbetriebspunkt in einen Reservebetriebspunkt, in dem die Windenergieanlage gegenüber dem Drosselbetriebspunkt mit höherer Abgabeleistung betrieben wird, als Reaktion auf eine Leistungserhöhungsanforderung, wobei
   das Betreiben der Windenergieanlage derart implementiert ist, dass
- der Drosselbetriebspunkt gegenüber dem Reservebetriebspunkt eine erhöhte Schnelllaufzahl aufweist und
- der Drosselbetriebspunkt in dem λθ-Diagramm auf einer zugehörigen Iso-Kennlinie liegt und die zugehörige Iso-Kennlinie in dem Drosselbetriebspunkt eine negative Kennliniensteigung aufweist, bei der die Schnelllaufzahl mit steigendem Blattwinkel abnimmt, wobei die Kennliniensteigung im Drosselbetriebspunkt mit einem Wert abnimmt, der dem Betrage nach wenigstens 0,5/1° beträgt.

Die Windenergieanlage weist somit eine Steuerungseinrichtung auf und ist dazu vorbereitet, die Windenergieanlage im Teillastbereich zu betreiben und sie so zu betreiben, dass dabei die Windenergieanlage in einem Normalbetriebspunkt betrieben wird, in einem Drosselbetriebspunkt betrieben wird oder in einem Reservebetriebspunkt betrieben wird, je nach Anforderung. Dazu gehört auch, den Betrieb der Windenergieanlage aus dem Drosselbetriebspunkt in den Reservebetriebspunkt zu wechseln, wenn eine entsprechende Leistungserhöhungsanforderung vorliegt. All das ist in der Steuerungseinrichtung implementiert. Insbesondere kann dafür ein entsprechendes Programm hinterlegt und implementiert sein. Die konkreten Vorgaben für die jeweiligen Betriebspunkte können ebenfalls durch entsprechend funktionale Zusammenhänge hinterlegt sein. Außerdem oder alternativ können zu unterschiedlichen Windgeschwindigkeiten unterschiedliche Betriebspunkte hinterlegt sein und je nach Windgeschwindigkeit und Anforderung ausgewählt werden. Zwischenpunkte, also Betriebspunkte für Windgeschwindigkeiten, für die kein Betriebspunkt hinterlegt ist, können durch Interpolation aus benachbarten Betriebspunkten bestimmt werden.

Besonders ist das Betreiben der Windenergieanlage derart implementiert, dass der Drosselbetriebspunkt gegenüber dem Reservebetriebspunkt eine erhöhte Schnelllaufzahl aufweist und der Drosselbetriebspunkt in dem λθ-Diagramm auf einer zugehörigen Iso-Kennlinie liegt und die zugehörige Iso-Kennlinie in dem Drosselbetriebspunkt eine negative Kennliniensteigung aufweist, bei der die Schnelllaufzahl mit steigendem Blattwinkel abnimmt. Alle diese Zusammenhänge können funktional implementiert sein und/oder dadurch, dass windgeschwindigkeitsabhängig Betriebspunkte hinterlegt sind, die diese Kriterien erfüllen.

Insbesondere wird vorgeschlagen, dass die Windenergieanlage, insbesondere die Steuerungseinrichtung, dazu vorbereitet ist, ein Verfahren gemäß einer der vorstehend beschriebenen Ausführungsformen auszuführen. Besonders ist das entsprechende Steuerverfahren in der Steuerungseinrichtung implementiert.

Gemäß einer Ausführungsform wird vorgeschlagen, dass eine Datenschnittstelle vorgesehen ist, zum Empfangen und Auswerten eines externen Signals als externe Vorgabe der Drosselanforderung. Die Drosselanforderung kann also als externes Signal und damit als externe Vorgabe von extern, beispielsweise von einem Netzbetreiber, übermittelt werden. Mit der Datenschnittstelle wird ein solches Signal empfangen und ausgewertet. Zumindest erfolgt die Auswertung so, dass das empfangene Signal als Drosselanforderung erkannt wird und dann weiter in der Steuerungseinrichtung verarbeitet werden kann.

Außerdem wird vorgeschlagen, dass eine Erfassungseinrichtung zum Erfassen und Auswerten eines Zustandes des elektrischen Versorgungsnetzes vorgesehen ist. Eine solche Erfassungseinrichtung kann besonders als schnelle Spannungserfassungseinrichtung vorgesehen sein, mit der beispielweise an entsprechenden Anschlussklemmen der Windenergieanlage die Netzspannung und damit insbesondere auch ihre Frequenz erfasst wird. Ein so erfasster Zustand wird zudem ausgewertet, um zu prüfen, ob eine Leistungserhöhungsanforderung als Vorschrift zur Reaktion auf den erfassten Zustand vorliegt. Es wird also beispielsweise die erfasste Spannung hinsichtlich ihrer Frequenz ausgewertet und geprüft, ob diese Frequenz einen solchen Wert aufweist, insbesondere eine solche Abweichung zu einem Normalzustand aufweist, dass dies so auszuwerten ist, dass eine Leistungserhöhungsanforderung vorliegt. Entsprechend wird dann auf eine solche Leistungserhöhungsanforderung reagiert.

Gemäß einer Ausführungsform wird vorgeschlagen, dass ein Steuerungsspeicher vorgesehen ist und in dem Steuerungsspeicher Steuerungsvorschriften hinterlegt sind, zum Betreiben der Windenergieanlage gemäß wenigstens einem Verfahren gemäß einer vorstehend beschriebenen Ausführungsform. Entsprechende Steuerungsvorschriften können somit in dem Steuerungsspeicher abgespeichert sein.

Außerdem oder alternativ wird vorgeschlagen, dass in dem Steuerungsspeicher Betriebspunkte gespeichert werden, also hinterlegt sind, die von der Windgeschwindigkeit abhängen. Insbesondere wird dies für mehrere Windgeschwindigkeiten vorgeschlagen und dabei ist zu jeder dieser mehreren Windgeschwindigkeiten jeweils ein Normalbetriebspunkt, ein Drosselbetriebspunkt und ein Reservebetriebspunkt hinterlegt. Diese drei Betriebspunkte sind entsprechend so ausgewählt, dass sie die vorstehend beschriebenen Zusammenhänge zwischen diesen drei Betriebspunkten erfüllen. Entsprechend können diese Betriebspunkte für unterschiedliche Windgeschwindigkeiten vor Inbetriebnahme einer Windenergieanlage ermittelt werden und dann implementiert werden. So können diese Betriebspunkte beispielsweise in Simulationen darauf überprüft werden, ob die Kriterien erfüllt sind. Es kommt auch in Betracht, die Betriebspunkte im laufenden Betrieb der Windenergieanlage in einem Offline-Verfahren zu überprüfen, um beispielsweise erkannten geänderten Eigenschaften der Windenergieanlage Rechnung zu tragen. Solche erneut bestimmten Betriebspunkte können dann in der Windenergieanlage implementiert werden.

Die Erfindung wird nun nachfolgend anhand von Ausführungsbeispielen unter Bezugnahme auf die begleitenden Figuren näher erläutert.
- Figur 1: zeigt eine Windenergieanlage in einer perspektivischen Darstellung.
- Figur 2: zeigt ein Leistungs-Drehzahldiagramm für unterschiedliche Windgeschwindigkeiten.
- Figur 3: zeigt ein λθ-Diagramm.
- Figur 4: zeigt ein Zeitdiagramm zum Veranschaulichen eines Übergangs von einem Drosselbetriebspunkt zu einem Reservebetriebspunkt.

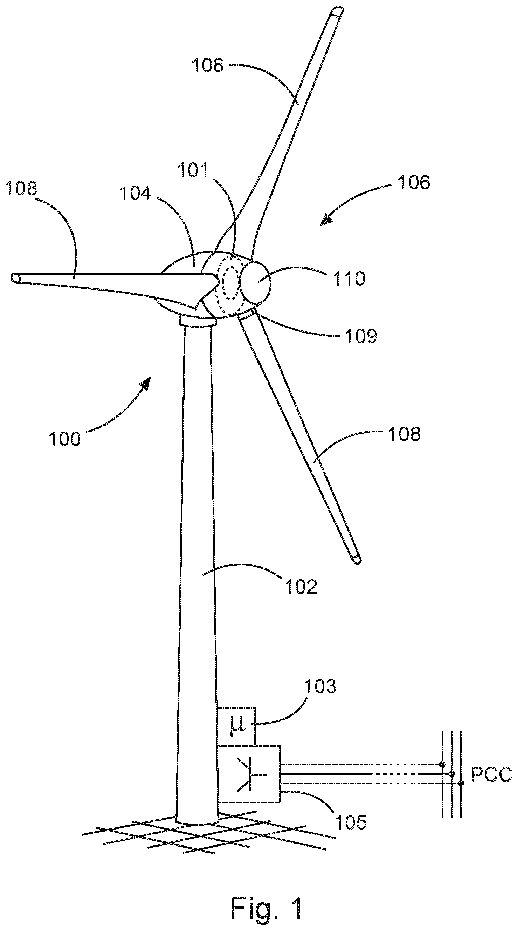

Figur 1 zeigt eine schematische Darstellung einer Windenergieanlage gemäß der Erfindung. Die Windenergieanlage 100 weist einen Turm 102 und eine Gondel 104 auf dem Turm 102 auf. An der Gondel 104 ist ein aerodynamischer Rotor 106 mit drei Rotorblättern 108 und einem Spinner 110 vorgesehen. Der aerodynamische Rotor 106 wird im Betrieb der Windenergieanlage durch den Wind in eine Drehbewegung versetzt und dreht somit auch einen elektrodynamischen Rotor oder Läufer eines Generators, welcher direkt oder indirekt mit dem aerodynamischen Rotor 106 gekoppelt ist. Der elektrische Generator ist in der Gondel 104 angeordnet und erzeugt elektrische Energie. Die Pitchwinkel der Rotorblätter 108 können durch Pitchmotoren an den Rotorblattwurzeln 109 der jeweiligen Rotorblätter 108 verändert werden.

Die Windenergieanlage 100 weist dabei einen elektrischen Generator 101 auf, der in der Gondel 104 angedeutet ist. Mittels des Generators 101 kann elektrische Leistung erzeugt werden. Zum Einspeisen elektrischer Leistung ist eine Einspeiseeinheit 105 vorgesehen, die besonders als Wechselrichter ausgebildet sein kann. Damit kann ein dreiphasiger Einspeisestrom und/oder eine dreiphasige Einspeisespannung nach Amplitude, Frequenz und Phase erzeugt werden, zum Einspeisen an einem Netzanschlusspunkt PCC. Das kann direkt oder auch gemeinsam mit weiteren Windenergieanlagen in einem Windpark erfolgen. Zum Steuern der Windenergieanlage 100 und auch der Einspeiseeinheit 105 ist eine Anlagensteuerung 103 vorgesehen. Die Anlagensteuerung 103 kann auch Vorgabewerte von extern, insbesondere von einem zentralen Parkrechner erhalten.

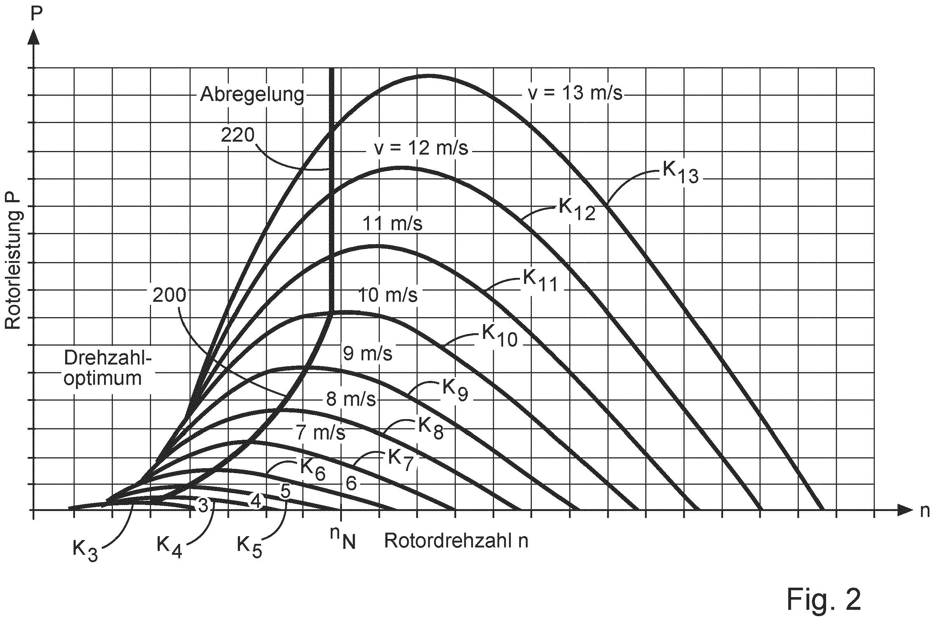

Figur 2 zeigt ein Diagramm in dem für unterschiedliche Windgeschwindigkeiten Kennlinien eingezeichnet sind, die den Zusammenhang zwischen Rotorleistung P und Rotordrehzahl n zeigen. Dabei sind Kennlinien k₃ - k₁₃ dargestellt. Der Index bezieht sich jeweils auf den zugehörigen Wert der Windgeschwindigkeit, nämlich von 3 m/s für k₃ bis 13 m/s für k₁₃. Es ist zu erkennen, dass bei jeder der Kennlinien k₃ - k₁₃ die erzeugbare Leistung P mit zunehmender Drehzahl n zunächst zunimmt, bis ein Maximum erreicht wird. Ab dem Maximum nimmt die Leistung P mit zunehmender Drehzahl n dann wieder ab. Für den optimalen Betrieb, also für einen optimalen Leistungsbeiwert und damit maximale Leistungserzeugung wird die Windenergieanlage jeweils in dem Maximum der Kennlinien betrieben.

Das ist als optimale Betriebskennlinie 200 in Figur 2 eingezeichnet. Allerdings kann die Windenergieanlage nicht mit beliebig hoher Drehzahl betrieben werden, sondern sollte eine Nenndrehzahl n_{N} nicht überschreiten. Diese Nenndrehzahl n_{N} ist in dem Diagramm eingezeichnet. Für Windgeschwindigkeiten von 10 m/s ist das Maximum der betreffenden Kennlinie, also der Kennlinie k₁₀, etwa im Bereich der Nenndrehzahl. Bei Kennlinien höherer Windgeschwindigkeiten, also bei den Kennlinien k₁₁ - k₁₃ liegen die Maxima bei höheren Drehzahlen und entsprechend knickt die optimale Betriebskennlinie beim Erreichen des Maximums der Kennlinie k₁₀ ein und verläuft ab da senkrecht. Ab da wird die Windenergieanlage nicht mehr im optimalen Betrieb betrieben, nämlich, um sie vor Überlast zu schützen.

Die optimale Betriebskennlinie 200 betrifft somit bis zu diesem Knick bei der Kennlinie k₁₀ den Teillastbereich, bei dem die Windenergieanlage noch nicht maximale Leistung erzeugen kann. Der senkrechte Bereich ist insoweit eine abgeregelte Kennlinie 220.

Somit wurde besonders erkannt, dass für niedrige Windgeschwindigkeiten sowohl eine Drehzahlerhöhung als auch eine Drehzahlverringerung zur Leistungsreduzierung in Betracht kommt. Besonders wurde erkannt, dass hierdurch ein Freiheitsgrad bei der Wahl eines Drosselbetriebspunktes ausgenutzt werden kann.

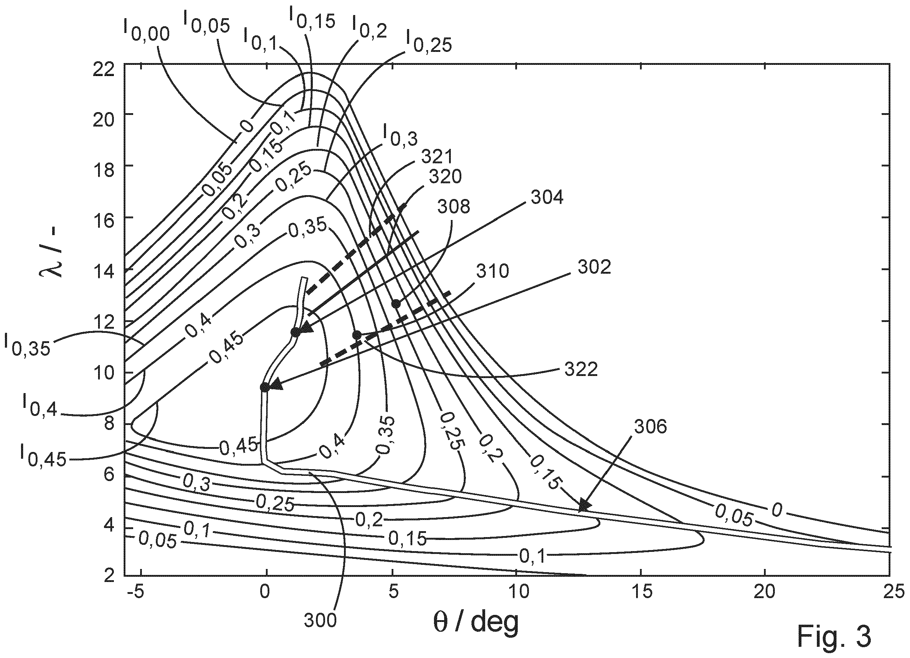

Figur 3 zeigt ein λθ-Diagramm bzw. einen Ausschnitt daraus. Darin ist die Schnelllaufzahl λ an der Ordinate dargestellt und der Blattwinkel θ an der Abszisse mit der Einheit Grad (°). Die einheitenlose Schnelllaufzahl λ ist somit über dem Blattwinkel θ aufgetragen. In dem λθ-Diagramm sind zudem Iso-Kennlinien E_{0,45} bis E_{0,00} eingetragen. Der Index gibt dabei jeweils den zugehörigen Leistungsbeiwert der betreffenden Kennlinie an. Der Leistungsbeiwert der Iso-Kennlinie I_{0,45} beträgt somit 0,45. Die Iso-Kennlinien sind dabei beginnend für einen Cp-Wert von 0,45 in gleichmäßigen 0,05-Schritten bis zum Cp-Wert von 0,05 und als letzten Wert von 0,00 eingezeichnet. Der Unterschied des Cp-Wertes zwischen zwei benachbarten Iso-Kennlinien beträgt somit immer 0,05.

In dem Diagramm ist zudem eine Anlagenbetriebskennlinie 300 eingezeichnet. Diese Anlagenbetriebskennlinie 300 gibt die Gesamtheit der Betriebspunkte der Windenergieanlage wieder, die sich je nach Windgeschwindigkeit einstellen, wenn keine gesonderte Drosselanforderung vorliegt. Ein optimaler Betriebspunkt 302 liegt quasi im Zentrum der Iso-Kennlinie I_{0,45} für einen Cp-Wert von 0,45. Der Cp-Wert des optimalen Betriebspunktes 302 dürfte noch geringfügig höher liegen. Die Anlagenbetriebskennlinie 300 ist zwar eine Kennlinie, entlang derer sich die Betriebspunkte verändern können, es kann dennoch sein, dass bei dem optimalen Betriebspunkt 302 der Betrieb der Windenergieanlage für einen größeren Bereich von Windgeschwindigkeiten durchgeführt wird. Mit anderen Worten können an dem optimalen Betriebspunkt 302 sehr viele Betriebspunkte für unterschiedliche Windgeschwindigkeiten quasi aufeinanderliegen.

Dennoch kann dieser optimale Betriebspunkt 302 mit der Windgeschwindigkeit variieren. Aufgrund von Randbedingungen ist zu erwarten, dass bei sehr geringen Windgeschwindigkeiten, zum Beispiel unterhalb von 5 m/s, eine höhere Schnelllaufzahl sinnvoll ist. Entsprechend kann dann auch eine geringe Veränderung des Blattwinkels θ sinnvoll sein. Um das zu veranschaulichen, ist ein suboptimaler Betriebspunkt 304 für niedrige Windgeschwindigkeiten eingezeichnet bzw. der Ast der Anlagenbetriebskennlinie 300 in der Nähe des suboptimalen Betriebspunktes 304 steht generell für den Betrieb bei geringen Windgeschwindigkeiten.

Bei hohen Windgeschwindigkeiten wird sich zum Ende des Teillastbereichs hin und darüber hinaus die Schnelllaufzahl mit zunehmender Windgeschwindigkeit verringern. Beim Verlassen des Teillastbereichs wird dann zur Abregelung der Windenergieanlage der Blattwinkel θ erhöht. Das ist durch den abgeregelten Kennlinienzweig 306 gekennzeichnet.

Um im Falle einer Drosselanforderung, wenn also die Windenergieanlage dauerhaft weniger Leistung im Teillastbereich abgeben soll als sie aus dem Wind erzeugen könnte, einen Drosselbetriebspunkt zu wählen, gibt es viele Optionen. Zunächst sollte, idealerweise ausgehend von dem optimalen Betriebspunkt 302, ein Betriebspunkt gefunden werden, bei dem der Leistungsbeiwert entsprechend geringer ist als beim optimalen Betriebspunkt 302. Soll die Windenergieanlage in dem Drosselbetriebspunkt beispielsweise etwa halb so viel Leistung erzeugen wie im optimalen Betriebspunkt, so wird vorgeschlagen, den Drosselbetriebspunkt auf der Iso-Kennlinie I_{0,25} zu wählen. Entsprechend ist in dem Diagramm der Figur 3 ein Drosselbetriebspunkt 308 eingezeichnet, als veranschaulichendes Beispiel.

Außerdem ist ein Reservebetriebspunkt 310 vorgesehen, der eine höhere Abgabeleistung aufweist als der Drosselbetriebspunkt 308 und daher beispielhaft auf der Iso-Kennlinie I_{0,40} für einen Leistungsbeiwert von 0,4 gewählt wurde.

Es wird nun vorgeschlagen, dass der Drosselbetriebspunkt 308 gegenüber dem Reservebetriebspunkt 310 eine erhöhte Schnelllaufzahl aufweist. Entsprechend sind diese beiden Betriebspunkte 308 und 310 in dem Diagramm der Figur 3 eingezeichnet. Wird nun von dem Drosselbetriebspunkt 308 auf den Reservebetriebspunkt 310 gewechselt, nämlich als Reaktion auf eine Leistungserhöhungsanforderung, so reduziert sich dafür die Drehzahl etwas, denn die Schnelllaufzahl λ muss sich dafür verringern. Bei Annahme gleicher Windgeschwindigkeit ist somit die Verringerung der Schnelllaufzahl eine Verringerung der Drehzahl. Dadurch kann kinetische Energie freigesetzt werden und dadurch sofort eine Leistungserhöhung erreicht werden, die bereits einsetzt, bevor der Reservebetriebspunkt 310 erreicht wurde.

In dem Diagramm der Figur 3 ist auch zu erkennen, dass der Drosselbetriebspunkt 308 auf einer zugehörigen Iso-Kennlinie liegt, also der Iso-Kennlinie I_{0,25}, die nämlich diesen gewünschten Cp-Wert von 0,25 aufweist, und dass diese Iso-Kennlinie I_{0,25} in diesem Drosselbetriebspunkt 308 eine negative Kennliniensteigung aufweist, bei der die Schnelllaufzahl mit steigendem Blattwinkel abnimmt. Hier ist die Steigung der Iso-Kennlinie I_{0,25} etwa -2,2/1°.

Aus dem Diagramm der Figur 3 ist zu erkennen, dass sich der Drosselbetriebspunkt 308 durch die vorgeschlagene Wahl, nämlich einschließlich durch die Wahl, dass die Kennliniensteigung im Drosselbetriebspunkt negativ ist, nicht in dem Bereich befindet, in dem die Anlagenbetriebskennlinie 308 bei geringen Windgeschwindigkeiten liegt oder liegen könnte. Es ist auch erkennbar, dass bei diesen Werten einer höheren Schnelllaufzahl als der Reservebetriebspunkt, dabei aber negativen Kennliniensteigung, die Kennlinien sehr dicht zusammen sind. Der dargestellte Abstand in der Figur 3 zwischen dem Drosselbetriebspunkt 308 und dem Reservebetriebspunkt 310 ist dadurch vergleichsweise gering. Um in dem gewählten Bereich von der Iso-Kennlinie I_{0,25} zur Iso-Kennlinie I_{0,4} zu gelangen, bedarf es nur einer Blattverstellung von weniger als 2°. Durch die vorgeschlagene Wahl des Drosselbetriebspunktes und des Reservebetriebspunktes, insbesondere durch die Wahl des Drosselbetriebspunktes in Bezug auf den Reservebetriebspunkt, kann diese schnelle Veränderungsmöglichkeit geschaffen werden.

In Figur 3 ist zudem eine Gradientenkennlinie 320 eingezeichnet, mit einer oberen Bandgrenze 321 und einer unteren Bandgrenze 322. Beide Bandgrenzen sind gestrichelt eingezeichnet und hier wurden unterschiedliche Werte für den Abstand der Bandgrenzen gewählt, so dass die Gradientenkennlinie in dem Band weiter nach oben zur oberen Bandgrenze liegt.

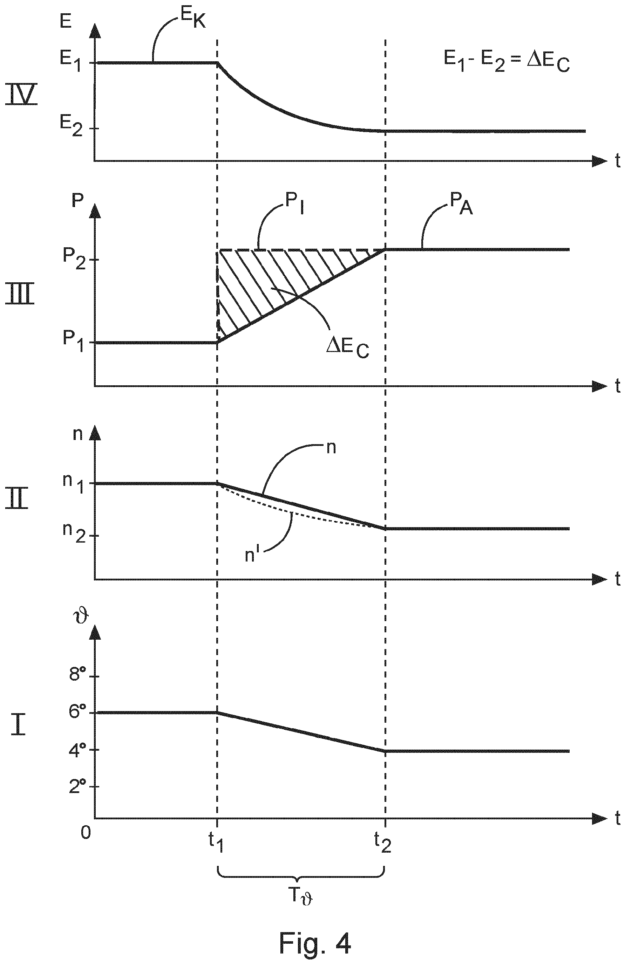

Figur 4 veranschaulicht eine bevorzugte Wahl des Drosselbetriebspunktes in Bezug auf den Reservebetriebspunkt unter Berücksichtigung der kinetischen Energie beider Betriebspunkte. Dazu sind in der Figur 4 mehrere zeitliche Verläufe dargestellt, nämlich in vier Einzeldiagrammen. Jedes Diagramm verwendet dieselbe Zeitachse. Die Figur 4 veranschaulicht dabei den Wechsel von einem Drosselbetriebspunkt in einen Reservebetriebspunkt. Dieser Wechsel beginnt zum Zeitpunkt t₁, zu dem der Drosselbetriebspunkt verlassen wird, und endet zum Zeitpunkt t₂, wenn der Reservebetriebspunkt erreicht wird. Der veranschaulichte Wechsel kann sich auf einen Wechsel des Drosselbetriebspunktes 308 in den Reservebetriebspunkt 310 gemäß Figur 3 beziehen.

Zur Veränderung des Drosselbetriebspunktes in den Reservebetriebspunkt wird der Blattwinkel beispielhaft von 6° nach 4° etwa linear verstellt. Das ist in dem unteren Diagramm I dargestellt, das als Diagramm des Blattwinkelverlaufs bezeichnet werden kann. Es wird angenommen, dass der Blattwinkel mit maximaler Verstellgeschwindigkeit verstellt wird und somit wird dafür die Blattverstellzeit Te benötigt, also die Differenz zwischen t₂ und t₁.

Zeitgleich damit, idealisierend ebenfalls etwa linear, verringert sich die Drehzahl n von dem Wert n₁ zum Zeitpunkt t₁, also die Drehzahl des Drosselbetriebspunktes, zur Drehzahl n₂ zum Zeitpunkt t₂, also die Drehzahl des Reservebetriebspunktes. Das ist in dem Diagramm II dargestellt, das somit ein Diagramm zum Darstellen des Drehzahlverlaufs bildet.

Der Drosselbetriebspunkt weist somit eine geringere Abgabeleistung mit dem Wert P₁ auf, wohingegen der Reservebetriebspunkt eine erhöhte Abgabeleistung mit dem Wert P₂ aufweist. Entsprechend erhöht sich die Abgabeleistung P_{A} von dem Wert P₁ zum Wert P₂, nämlich vom Zeitpunkt t₁ zum Zeitpunkt t₂.

Als Abgabeleistung P_{A} ist insoweit die Leistung zu verstehen, die die Windenergieanlage in dem jeweiligen Betriebspunkt aus Wind erzeugt und abgibt. Auch in dem Bereich zwischen den Zeitpunkten t₁ und t₂, also im Übergangsbereich, wenn der Wechsel zwischen dem Drosselbetriebspunkt und dem Reservebetriebspunkt stattfindet, ist unter der Abgabeleistung P_{A} diejenige zu verstehen, die aus dem Wind erzeugt wird.

Es wird nun aber vorgeschlagen, dass die eingespeiste Leistung im Übergangsbereich anfangs schneller erhöht wird, um möglichst schnell den Wert P₂ zu erreichen. Eine solche Leistung kann als instantane Leistung P_{I} bezeichnet werden und ist in dem dritten Diagramm III als gestrichelte Linie eingezeichnet. Dieses dritte Diagramm III bezeichnet somit ein Diagramm für den Verlauf der Leistung.

Im Idealfall kann aus der kinetischen Energie des Rotors der Windenergieanlage zum Zeitpunkt t₁ oder unmittelbar danach so viel Leistung entnommen werden, dass die Leistung sofort auf den Wert P₂ ansteigt. Es wird dann mehr Leistung in das elektrische Versorgungsnetz eingespeist als Abgabeleistung P_{A} vorhanden ist. Diese Abgabeleistung P_{A} nähert sich aber der instantanen Leistung P_{I} langsam an und erreicht sie zum Zeitpunkt t₂.

Aus der idealisierten Erhöhung der instantanen Leistung P_{I} gegenüber der Abgabeleistung P_{A} in der Zeit von t₁ bis t₂ ergibt sich somit ein etwa dreieckiger Bereich, der in diesem Diagramm III schraffiert dargestellt ist. Sein Flächeninhalt entspricht einer Energie, die als charakteristische Differenzenergie ΔE_{c} bezeichnet wird.

In dem vierten Diagramm IV wird zudem der Verlauf der kinetischen Energie Eₖ der Windenergieanlage dargestellt. Zwischen den Zeiten t₁ und t₂ entspricht der Verlauf der kinetischen Energie Eₖ etwa dem negativen Integral des in Diagramm III schraffiert dargestellten Leistungsdifferenzbereichs. Im Idealfall entspricht die Differenz der anfänglichen kinetischen Energie E₁ minus der zum Zeitpunkt t₂ erreichten kinetischen Energie E₂ der charakteristischen Differenzenergie ΔE_{c}.

Es ist zu beachten, dass diese Figur 4 der Veranschaulichung dient und idealisierend ist. Besonders ist natürlich zu beachten, dass sich bei dem sehr starken Anstieg der instantanen Leistung P_{I} kurz nach dem Zeitpunkt t₁ mit dem entsprechend stark abfallenden Energiewert der kinetischen Energie Eₖ auch die Drehzahl n stärker verringern würde, als dargestellt. Das ist in dem zweiten Diagramm II mit einer punktierten Linie angedeutet und als n' bezeichnet.

Ein entsprechend schnellerer Abfall der Drehzahl könnte auch Auswirkungen auf den Verlauf der Abgabeleistung P_{A} im Diagramm III haben. Allerdings würde ein schnellerer Abfall der Drehzahl n nicht zwangsläufig dazu führen, dass die Abgabeleistung P_{A} zur selben Zeit entsprechend schneller ansteigt, denn aus Figur 3 ist zu erkennen, dass ein schnellerer Abfall der Drehzahl, also ein schnellerer Abfall der Schnelllaufzahl, nicht unbedingt zu einer schnelleren Erhöhung des Leistungsbeiwertes führen würde.

Somit wurde erkannt, dass die charakteristische Differenzenergie ΔE_{c} in guter Näherung aus dem Produkt der Differenzabgabeleistung, also P₂ minus P₁, und der Blattverstellzeit Te und zusätzlich multipliziert mit 1/2 berechnet werden kann. Entsprechend wird vorgeschlagen, den Drosselbetriebspunkt und/oder den Reservebetriebspunkt so zu wählen, dass die Differenzrotationsenergie etwa in der Größe der charakteristischen Differenzenergie ΔE_{c} gewählt wird.

## Patentansprüche

1. Verfahren zum Steuern einer Windenergieanlage (100), wobei
- die Windenergieanlage (100) einen Rotor (106) mit in ihrem Blattwinkel (Θ) verstellbaren Rotorblättern (108) aufweist und der Rotor (106) mit einer variablen Drehzahl (n) betreibbar ist, und wobei
- die Windenergieanlage (100) in einem Teillastbereich betrieben wird, in dem nicht ausreichend Wind vorhanden ist, um die Windenergieanlage (100) mit Nennleistung (P_{N}) zu betreiben,
- die Windenergieanlage (100) in einem veränderlich vorgebbaren Betriebspunkt (302, 308, 310) betreibbar ist, und
- der Betriebspunkt (302, 308, 310) durch den Blattwinkel (θ) und eine Schnelllaufzahl (λ) gekennzeichnet ist, und wobei
- der Betriebspunkt (302, 308, 310) in einem λθ-Diagramm darstellbar ist, wobei
- in dem λθ-Diagramm die Schnelllaufzahl (λ) über dem Blattwinkel (Θ) aufgetragen ist, und
- der Betriebspunkt (302, 308, 310) in dem λθ-Diagramm als Wertepaar aus seinem Blattwinkel (Θ) und seiner Schnelllaufzahl (λ) darstellbar ist, wobei
- jedem Betriebspunkt (302, 308, 310) ein Leistungsbeiwert (Cp-Wert) zugeordnet ist, und
- mehrere Betriebspunkte (302, 308, 310) mit gleichem Cp-Wert als Iso-Kennlinie in dem λθ-Diagramm darstellbar sind,
umfassend die Schritte:
- Betreiben der Windenergieanlage in einem Normalbetriebspunkt (302), bei dem die Windenergieanlage (100) nicht gedrosselt betrieben wird, wenn keine Anforderung einer Drosselung vorliegt,
- Betreiben der Windenergieanlage (100) in einem Drosselbetriebspunkt (308), bei dem die Windenergieanlage (100) auf eine Drosselanforderung hin mit gegenüber dem Normalbetriebspunkt (302) gedrosselter Abgabeleistung (P_{A}) betrieben wird, und
- Wechseln des Betriebs der Windenergieanlage aus dem Drosselbetriebspunkt (308) in einen Reservebetriebspunkt (310), in dem die Windenergieanlage (100) gegenüber dem Drosselbetriebspunkt (308) mit höherer Abgabeleistung betrieben wird, als Reaktion auf eine Leistungserhöhungsanforderung, wobei
- der Drosselbetriebspunkt (308) gegenüber dem Reservebetriebspunkt (310) eine erhöhte Schnelllaufzahl aufweist und
- der Drosselbetriebspunkt (308) in dem λθ-Diagramm auf einer zugehörigen Iso-Kennlinie liegt und die zugehörige Iso-Kennlinie in dem Drosselbetriebspunkt (308) eine negative Kennliniensteigung aufweist, bei der die Schnelllaufzahl mit steigendem Blattwinkel abnimmt, **dadurch gekennzeichnet, dass** die Kennliniensteigung im Drosselbetriebspunkt (308) mit einem Wert abnimmt, der dem Betrage nach wenigstens 0,5/1° beträgt.

2. Verfahren nach Anspruch 1, **dadurch gekennzeichnet, dass**
- der Reservebetriebspunkt (310)
- gegenüber dem Normalbetriebspunkt (302) mit geringerer Abgabeleistung betrieben wird, und/oder
- gegenüber dem Drosselbetriebspunkt (308) eine reduzierte Schnelllaufzahl aufweist, und optional
- gegenüber dem Normalbetriebspunkt (302) eine erhöhte Schnelllaufzahl aufweist.

3. Verfahren nach Anspruch 1 oder 2, **dadurch gekennzeichnet, dass**
- der Drosselbetriebspunkt (308) und/oder
- der Reservebetriebspunkt (310)
in Abhängigkeit von
- einem Abstand zweier Iso-Kennlinien beim Drosselbetriebspunkt (308) bzw. beim Reservebetriebspunkt (310) und/oder
- einem Gradienten des Leistungsbeiwertes des Drosselbetriebspunktes (308) bzw. des Reservebetriebspunktes (310) ausgewählt wird.

4. Verfahren nach einem der vorstehenden Ansprüche, **dadurch gekennzeichnet, dass**
- der Drosselbetriebspunkt (308) und/oder der Reservebetriebspunkt (310) so ausgewählt werden, dass jeweils
- eine Ableitung des Leistungsbeiwertes (Cₚ) des Drosselbetriebspunktes (308) bzw. des Reservebetriebspunktes (310) nach dem Blattwinkel dem Betrage nach einen vorbestimmten Mindestableitungswert überschreitet, insbesondere dass
- für den Drosselbetriebspunkt (308) der Mindestableitungswert wenigstens 0,3/6° (=0,05/1°) beträgt und/oder
- für den Reservebetriebspunkt (310) der Mindestableitungswert wenigstens 0,1/6°beträgt.

5. Verfahren nach einem der vorstehenden Ansprüche,
**dadurch gekennzeichnet, dass**
- die Windenergieanlage (100) durch ein Kennlinienfeld aus Iso-Kennlinien in dem λθ-Diagramm charakterisiert werden kann, und
- das Kennlinienfeld als normiertes Kennlinienfeld definiert werden kann, in dem der Blattwinkel auf ganze Grad (°) normiert wird,
- in dem normierten Kennlinienfeld ein erster Teilbereich ausgebildet ist, in dem
- die Blattwinkel größer sind als der Blattwinkel des Normalbetriebspunktes, und
- die ISO-Kennlinien eine negative Kennliniensteigung aufweisen, bei der die Schnelllaufzahl mit steigendem Blattwinkel abnimmt,
- in dem normierten Kennlinienfeld jeder Betriebspunkt durch einen Gradientenwert gekennzeichnet ist, der die maximale Steigung des Leistungsbeiwertes des Betriebspunktes in dem normierten Kennlinienfeld quantifiziert,
- wobei in dem ersten Teilbereich des normierten Kennlinienfelds zu jeder Iso-Kennlinie ein Betriebspunkt mit maximalem Gradientenwert vorhanden ist und eine Gradientenkennlinie darstellbar ist, die alle diese Betriebspunkte mit maximalem Gradientenwert verbindet, wobei
- der Drosselbetriebspunkt (308) und/oder der Reservebetriebspunkt (310) so gewählt werden, dass sie jeweils auf der Gradientenkennlinie liegen, und/oder
- in einem die Gradientenkennlinie (320) einschließenden Gradientenband liegen, wobei
- das Gradientenband
- eine obere Bandgrenze (321) aufweist, die um eine obere Schnelllaufzahldifferenz oberhalb der Gradientenkennlinie liegt, und
- eine untere Bandgrenze (322) aufweist, die um eine untere Schnelllaufzahldifferenz unterhalb der Gradientenkennlinie liegt, wobei
- die obere und untere Schnelllaufzahldifferenz vorzugsweise jeweils maximal den Wert 2 aufweisen, insbesondere maximal den Wert 1 aufweisen, oder
- die obere Schnelllaufzahldifferenz maximal den Wert 1 aufweist und
- die untere Schnelllaufzahldifferenz maximal den Wert 4 aufweist.

6. Verfahren nach einem der vorstehenden Ansprüche,
**dadurch gekennzeichnet, dass** die Windenergieanlage (100)
- in dem Drosselbetriebspunkt (308)
- eine erste Abgabeleistung,
- eine erste Rotationsenergie und
- einen ersten Blattwinkel aufweist, und
- in dem Reservebetriebspunkt (310)
- eine zweite Abgabeleistung,
- eine zweite Rotationsenergie und
- einen zweiten Blattwinkel aufweist, wobei
- die erste Abgabenleistung kleiner als die zweite Abgabenleistung ist und eine Differenz zwischen der zweiten Abgabeleistung und der ersten Abgabeleistung eine Differenzabgabeleistung der Betriebspunkte bildet,
- die erste Rotationsenergie (E₁) größer als die zweite Rotationsenergie (E₂) ist, und eine Differenz zwischen der ersten und zweiten Rotationsenergie eine Differenzrotationsenergie bildet,
- zum Verstellen der Rotorblätter vom ersten Blattwinkel in den zweiten Blattwinkel eine Blattverstellzeit benötigt wird,
- ein Produkt der Differenzabgabeleistung mit der Blattverstellzeit multipliziert mit 50% eine charakteristische Differenzenergie (ΔE_{C}) bildet, und
- der Drosselbetriebspunkt (308) und/oder der Reservebetriebspunkt (310) so gewählt werden, dass die Differenzrotationsenergie maximal um einen vorbestimmten prozentualen Abweichungswert oberhalb oder unterhalb der charakteristischen Differenzenergie liegt, wobei der prozentuale Abweichungswert maximal 60% beträgt, vorzugsweise maximal 40%, insbesondere maximal 20%.

7. Verfahren nach einem der vorstehenden Ansprüche,
**dadurch gekennzeichnet, dass**
- zum Einstellen des Drosselbetriebspunktes, insbesondere ausgehend von dem Normalbetriebspunkt, zunächst in einem ersten Verstellschritt ein Zwischenbetriebspunkt eingestellt wird, wobei
- der Zwischenbetriebspunkt denselben Cp-Wert wie der Drosselbetriebspunkt aufweist, zumindest einen um weniger als 20% veränderten Cp-Wert aufweist, insbesondere, dass
- in einem zweiten Verstellschritt von dem Zwischenbetriebspunkt in den Drosselbetriebspunkt gewechselt wird und das Wechseln in dem λθ-Diagramm im Wesentlichen als Veränderung entlang einer Iso-Kennlinie darstellbar ist, zumindest mit einer maximalen Abweichung von 20% des Cp-Wertes der Iso-Kennlinie des Drosselbetriebspunktes.

8. Verfahren nach einem der vorstehenden Ansprüche,
**dadurch gekennzeichnet, dass**
- die Drosselanforderung zum Anfordern des Betriebs der Windenergieanlage im Drosselbetriebspunkt als externe Vorgabe ausgebildet ist, die über eine Datenschnittstelle empfangen wird, und/oder
- die Leistungserhöhungsanforderung zum Anfordern des Betriebs der Windenergieanlage in dem Reservebetriebspunkt als Vorschrift zur Reaktion auf einen von der Windenergieanlage erfassten Zustand des elektrischen Versorgungsnetzes ausgebildet ist, insbesondere als Vorschrift, eine Leistungserhöhung ausgehend von dem Drosselbetriebspunkt (308) in Abhängigkeit einer erfassten Netzfrequenz des elektrischen Versorgungsnetzes durchzuführen.

9. Verfahren nach einem der vorstehenden Ansprüche,
**dadurch gekennzeichnet, dass**
- die Windenergieanlage (100) für einen längeren Zeitraum in dem Drosselbetriebspunkt (308) betrieben wird, als in dem Reservebetriebspunkt (310), insbesondere wenigstens 20-mal so lange.

10. Windenergieanlage (100) mit
- einem Rotor (106) mit in ihrem Blattwinkel (Θ) verstellbaren Rotorblättern (108), wobei der Rotor (106) mit einer variablen Drehzahl betreibbar ist, und wobei
- die Windenergieanlage (100) in einem Teillastbereich betreibbar ist, in dem nicht ausreichend Wind vorhanden ist, um die Windenergieanlage mit Nennleistung (P_{N})zu betreiben,
- die Windenergieanlage (100) in einem veränderlich vorgebbaren Betriebspunkt (302, 308, 310) betreibbar ist, und
- der Betriebspunkt (302, 308, 310) durch den Blattwinkel (θ) und eine Schnelllaufzahl (λ) gekennzeichnet ist, und wobei
- der Betriebspunkt (302, 308, 310) in einem λθ-Diagramm darstellbar ist, wobei
- in dem λθ-Diagramm die Schnelllaufzahl (λ) über dem Blattwinkel (Θ) aufgetragen ist, und
- der Betriebspunkt (302, 308, 310) in dem λθ-Diagramm als Wertepaar aus seinem Blattwinkel (θ) und seiner Schnelllaufzahl (λ) darstellbar ist, wobei
- jedem Betriebspunkt (302, 308, 310) ein Leistungsbeiwert (Cp-Wert) zugeordnet ist, und
- mehrere Betriebspunkte (302, 308, 310) mit gleichem Cp-Wert als Iso-Kennlinie in dem λθ-Diagramm darstellbar sind,
und die Windenergieanlage (100) weist eine Steuerungseinrichtung (103) auf, dazu vorbereitet, die Windenergieanlage (100) im Teillastbereich zu betreiben, und dabei vorbereitet
- zum Betreiben der Windenergieanlage in einem Normalbetriebspunkt (302), bei dem die Windenergieanlage nicht gedrosselt betrieben wird, wenn keine Anforderung einer Drosselung vorliegt,
- zum Betreiben der Windenergieanlage (100) in einem Drosselbetriebspunkt (308), bei dem die Windenergieanlage (100) auf eine Drosselanforderung hin mit gegenüberdem Normalbetriebspunkt (302) gedrosselter Abgabeleistung betrieben wird, und
- zum Wechseln des Betriebs der Windenergieanlage aus dem Drosselbetriebspunkt (308) in einen Reservebetriebspunkt (310), in dem die Windenergieanlage gegenüber dem Drosselbetriebspunkt (308) mit höherer Abgabeleistung betrieben wird, als Reaktion auf eine Leistungserhöhungsanforderung, wobei das Betreiben der Windenergieanlage (100) derart implementiert ist, dass
- der Drosselbetriebspunkt (308) gegenüber dem Reservebetriebspunkt (310) eine erhöhte Schnelllaufzahl aufweist und
- der Drosselbetriebspunkt (308) in dem λθ-Diagramm auf einer zugehörigen Iso-Kennlinie liegt und die zugehörige Iso-Kennlinie in dem Drosselbetriebspunkt (308) eine negative Kennliniensteigung aufweist, bei der die Schnelllaufzahl mit steigendem Blattwinkel abnimmt, **dadurch gekennzeichnet, dass** die Kennliniensteigung im Drosselbetriebspunkt (308) mit einem Wert abnimmt, der dem Betrage nach wenigstens 0,5/1° beträgt.

11. Windenergieanlage nach Anspruch 10,
**dadurch gekennzeichnet, dass** die Windenergieanlage, insbesondere die Steuerungseinrichtung (103), dazu vorbereitet ist, ein Verfahren nach einem der Ansprüche 1 bis 9 auszuführen.

12. Windenergieanlage (100) nach Anspruch 10 oder 11,
**dadurch gekennzeichnet, dass**
- eine Datenschnittstelle vorgesehen ist, zum Empfangen und Auswerten eines externen Signals als externe Vorgabe der Drosselanforderung, und
- eine Erfassungseinrichtung zum Erfassen und Auswerten eines Zustandes des elektrischen Versorgungsnetzes zum Prüfen auf eine Leistungserhöhungsanforderung als Vorschrift zur Reaktion auf den erfassten Zustand.

13. Windenergieanlage (100) nach einem der Ansprüche 10 bis 12,
**dadurch gekennzeichnet, dass** ein Steuerungsspeicher vorgesehen ist und in dem Steuerungsspeicher
- Steuerungsvorschriften hinterlegt sind zum Betreiben der Windenergieanlage gemäß wenigstens einem Verfahren nach einem der Ansprüche 1 bis 9, und/oder
- Betriebspunkte von der Windgeschwindigkeit abhängige Betriebspunkte hinterlegt sind, insbesondere zu mehreren Windgeschwindigkeiten jeweils ein Normalbetriebspunkt, ein Drosselbetriebspunkt und ein Reservebetriebspunkt hinterlegt sind.

## Claims

1. A method for controlling a wind power installation (100), wherein
- the wind power installation (100) has a rotor (106) with rotor blades (108) with an adjustable blade angle (θ), and the rotor (106) can be operated with a variable rotational speed (n), and wherein
- the wind power installation (100) is operated in a partial load range in which sufficient wind is not present to operate the wind power installation (100) with rated power (PN),
- the wind power installation (100) can be operated as an operating point (302, 308, 310) which can be specified in a changing fashion, and
- the operating point (302, 308, 310) is **characterized by** the blade angle (Θ) and a tip speed ratio (λ), and wherein
- the operating point (302, 308, 310) can be represented in a λθ diagram, wherein
- in the λθ diagram the tip speed ratio (A) is plotted against the blade angle (θ), and
- the operating point (302, 308, 310) can be represented in the λθ diagram as a value pair composed of a blade angle (θ) and tip speed ratio (λ), wherein
- each operating point (302, 308, 310) is assigned a power coefficient (Cp value), and
- a plurality of operating points (302, 308, 310) with the same Cp value can be represented as an iso-characteristic curve in the λθ diagram,
comprising the steps:
- operating the wind power installation at a normal operating point (302) at which the wind power installation (100) is not operated in a throttled fashion if there is no request for throttling,
- operating the wind power installation (100) at a throttled operating point (308) at which, in response to a throttle request, the wind power installation (100) is operated with output power (P_{A}) which is throttled in comparison with the normal operating point (302), and
- changing over the operation of the wind power installation from the throttled operating point (308) to a reserve operating point (310) at which the wind power installation (100) is operated with higher output power in comparison with the throttled operating point (308), in reaction to a power increase request wherein
- the throttled operating point (308) has an increased tip speed ratio in comparison with the reserve operating point (310), and
- the throttled operating point (308) lies on an associated iso-characteristic curve in the λθ diagram, and the associated iso-characteristic curve has, at the throttled operating point (308), a negative characteristic curve gradient at which the tip speed ratio decreases as the blade angle increases, **characterized in that**
the characteristic curve gradient at the throttled operating point (308) decreases with a value which is at least 0.5/1° in terms of absolute value.

2. The method as claimed in claim 1, wherein
- the reserve operating point (310)
- is operated with lower output power in comparison with the normal operating point (302), and/or
- has a reduced tip speed ratio in comparison with the throttled operating point (308), and optionally
- has an increased tip speed ratio in comparison with the normal operating point (302).

3. the method as claimed in claim 1 or 2, wherein
- the throttled operating point (308) and/or
- the reserve operating point (310)
is selected as a function of
- a distance between two iso-characteristic curves at the throttled operating point (308) or at the reserve operating point (310) and/or
- a gradient of the power coefficient of the throttled operating point (308) or of the reserve operating point (310).

4. The method as claimed in one of the preceding claims, wherein
- the throttled operating point (308) and/or the reserve operating point (310) are selected in such a way that in each case
- a derivative of the power coefficient (C_{P}) of the throttled operating point (308) or of the reserve operating point (310) according to the blade angle exceeds a predetermined minimum derivative value in terms of the absolute value, in particular in such a way that
- for the throttled operating point (308) the minimum derivative value is at least 0.3/6° (= 0.05/1 °) and/or
- for the reserve operating point (310) the minimum derivative value is at least 0.1/6°.

5. The method as claimed in one of the preceding claims,
wherein
- the wind power installation (100) can be **characterized by** a characteristic curve diagram composed of iso-characteristic curves in the λθ diagram, and
- the characteristic curve diagram can be defined as a standardized characteristic curve diagram in which the blade angle is standardized to entire degrees (°),
- in the standardized characteristic curve diagram a first sub-region is formed in which
- the blade angles are greater than the blade angles of the normal operating point and
- the iso-characteristic curves have a negative characteristic curve gradient in which the tip speed ratio decreases as the blade angle increases,
- in the standardized characteristic curve diagram each operating point is **characterized by** a gradient value which quantifies the maximum gradient of the power coefficient of the operating point in the standardized characteristic curve diagram,
- wherein in the first sub-region of the standardized characteristic curve diagram there is an operating point with a maximum gradient value for each iso-characteristic curve, and a gradient characteristic curve can be represented which connects all these operating points with a maximum gradient value, wherein
- the throttled operating point (308) and/or the reserve operating point (310) are selected such that they each lie on the gradient characteristic curve, and/or
- lie in a gradient band including the gradient characteristic curve (320),
- wherein the gradient band has
- an upper band limit (321) which lies above the gradient characteristic curve by a tip speed ratio difference, and
- a lower band limit (322) which lies below the gradient characteristic curve by a lower tip speed ratio difference, wherein
- the upper and lower tip speed ratio differences preferably each have at maximum the value 2, in particular at maximum the value 1, or
- the upper tip speed ratio difference has at maximum the value 1 and
- the lower tip speed ratio difference has at maximum the value 4.

6. The method as claimed in one of the preceding claims,
wherein the wind power installation (100) has
- at the throttled operating point (308)
- a first output power level,
- a first rotational energy level and
- a first blade angle, and
- at the reserve operating point (310)
- a second output power level,
- a second rotational energy level and
- a second blade angle, wherein
- the first output power level is lower than the second output power level, and a difference between the second output power level and the first output power level forms a differential output power level of the operating points,
- the first rotational energy level (E₁) is higher than the second rotational energy level (E₂), and a difference between the first and second rotational energy levels forms a difference rotational energy level,
- a blade adjustment time is required to adjust the rotor blades from the first blade angle to the second blade angle,
- a product of the differential output power level with the blade adjustment time multiplied by 50% forms a characteristic differential energy level (ΔE_{C}), and
- the throttled operating point (308) and/or the reserve operating point (310) are selected in such a way that the difference rotational energy level lies above or below the characteristic differential energy level by a maximum predetermined percentage deviation value, wherein the percentage deviation value is at maximum 60%, preferably at maximum 40% and in particular at maximum 20%.

7. The method as claimed in one of the preceding claims,
wherein
- in order to set the throttled operating point, in particular starting from the normal operating point, an intermediate operating point is firstly set in a first adjustment step, wherein
- the intermediate operating point has the same Cp value as the throttled operating point, at least a Cp value which is changed by less than 20%, in particular in that
- in a second adjustment step there is a changeover from the intermediate operating point to the throttled operating point, and the changeover can be represented in the λθ diagram essentially as a change along an iso-characteristic curve, at least with a maximum deviation of 20% of the Cp value of the iso-characteristic curve of the throttled operating point.

8. The method as claimed in one of the preceding claims,
wherein
- the throttle request to request the operation of the wind power installation at the throttled operating point is embodied as an external specification which is received by a data interface, and/or
- the power increase request to request the operation of the wind power installation at the reserve operating point is embodied as a prescription for reaction to a state of the electric supply network which is sensed by the wind power installation, in particular as a prescription to carry out a power increase starting from the throttled operating point (308) as a function of a sensed network frequency of the electric supply network.

9. The method as claimed in one of the preceding claims,
wherein
- the wind power installation (100) is operated for a longer time period at the throttled operating point (308) than at the reserve operating point (310), in particular at least 20 times as long.

10. A wind power installation (100) with
- a rotor (106) with rotor blades (108) with an adjustable blade angle (θ), wherein the rotor (106) can be operated with a variable rotational speed, and wherein
- the wind power installation (100) can be operated in a partial load range in which sufficient wind is not present to operate the wind power installation with rated power (PN),
- the wind power installation (100) can be operated as an operating point (302, 308, 310) which can be specified in a changing fashion, and
- the operating point (302, 308, 310) is **characterized by** the blade angle (Θ) and a tip speed ratio (λ), and wherein
- the operating point (302, 308, 310) can be represented in a λθ diagram, wherein
- in the λθ diagram the tip speed ratio (A) is plotted against the blade angle (θ), and
- the operating point (302, 308, 310) can be represented in the λθ diagram as a value pair composed of a blade angle (θ) and tip speed ratio (λ), wherein
- each operating point (302, 308, 310) is assigned a power coefficient (Cp value), and
- a plurality of operating points (302, 308, 310) with the same Cp value can be represented as an iso characteristic curve in the λθ diagram, and the wind power installation (100) has a control device (103), prepared to operate the wind power installation (100) in the partial load range, and at the same time prepares
- to operate the wind power installation at a normal operating point (302) at which the wind power installation (100) is not operated in a throttled fashion if there is no request for throttling,
- to operate the wind power installation (100) at a throttled operating point (308) at which, in response to a throttle request, the wind power installation (100) is operated with output power which is throttled in comparison with the normal operating point (302), and
- to changeover the operation of the wind power installation from the throttled operating point (308) to a reserve operating point (310) at which the wind power installation is operated with higher output power in comparison with the throttled operating point (308), in reaction to a power increase request wherein
the operation of the wind power installation (100) is implemented in such a way that
- the throttled operating point (308) has an increased tip speed ratio in comparison with the reserve operating point (310), and
- the throttled operating point (308) lies on an associated iso-characteristic curve in the λθ diagram, and the associated iso-characteristic curve has, at the throttled operating point (308), a negative characteristic curve gradient at which the tip speed ratio decreases as the blade angle increases, **characterized in that**
the characteristic curve gradient at the throttled operating point (308) decreases with a value which is at least 0.5/1° in terms of absolute value.

11. The wind power installation as claimed in claim 10,
wherein the wind power installation, in particular the control device (103), is prepared to carry out a method as claimed in one of claims 1 to 9.

12. The wind power installation (100) as claimed in claim 10 or 11,
wherein
- a data interface is provided for receiving and evaluating an external signal as an external specification of the throttling request, and
- a sensing device for sensing and evaluating a state of the electric supply network for checking for a power increase request as a prescription for reaction to the sensed state.

13. The wind power installation (100) as claimed in one of claims 10 to 12,
wherein a control memory is provided, and in the control memory,
- control prescriptions are stored for operating the wind power installation according to at least one method as claimed in one of claims 1 to 9, and/or
- operating points are stored operating points which are dependent on the wind speed, in particular in each case a normal operating point, a throttled operating point and a reserve operating point are stored for a plurality of wind speeds.

## Revendications

1. Procédé pour commander une éolienne (100), dans lequel
- l'éolienne (100) présente un rotor (106) avec des pales de rotor (108) réglables dans leur angle de pale (Θ) et le rotor (106) peut fonctionner avec une vitesse de rotation (n) variable, et dans lequel
- l'éolienne (100) fonctionne dans une plage de charge partielle dans laquelle insuffisamment de vent est présent pour faire fonctionner l'éolienne (100) avec une puissance nominale (P_{N}),
- l'éolienne (100) peut fonctionner dans un point de fonctionnement (302, 308, 310) pouvant être prédéfini de manière variable, et
- le point de fonctionnement (302, 308, 310) est **caractérisé par** l'angle de pale (Θ) et une vitesse spécifique (λ), et dans lequel
- le point de fonctionnement (302, 308, 310) peut être représenté dans un diagramme λθ, dans lequel
- dans le diagramme λθ la vitesse spécifique (X) sur l'angle de pale (Θ) est tracée, et
- le point de fonctionnement (302, 308, 310) peut être représenté dans le diagramme λθ en tant que paire de valeurs composée de son angle de pale (Θ) et de sa vitesse spécifique (λ), dans lequel
- un coefficient de puissance (valeur Cₚ) est associé à chaque point de fonctionnement (302, 308, 310), et
- plusieurs points de fonctionnement (302, 308, 310) avec la même valeur Cₚ peuvent être représentés en tant que courbe caractéristique Iso dans le diagramme λθ,
comprenant les étapes de :
- fonctionnement de l'éolienne dans un point de fonctionnement normal (302), pour lequel l'éolienne (100) fonctionne de façon non restreinte, lorsqu'aucune demande d'une restriction n'est présente,
- fonctionnement de l'éolienne (100) dans un point de fonctionnement restreint (308), pour lequel l'éolienne (100), à la suite d'une demande de restriction, fonctionne avec une puissance de sortie (P_{A}) restreinte par rapport au point de fonctionnement normal (302), et
- passage du fonctionnement de l'éolienne à partir du point de fonctionnement restreint (308) dans un point de fonctionnement de secours (310) dans lequel l'éolienne (100) fonctionne avec une puissance de sortie plus élevée par rapport au point de fonctionnement restreint (308), en réponse à une demande d'augmentation de puissance, dans lequel
- le point de fonctionnement restreint (308) présente, par rapport au point de fonctionnement de secours (310), une vitesse spécifique accrue et
- le point de fonctionnement restreint (308) se situe dans le diagramme λθ sur une courbe caractéristique Iso associée et la courbe caractéristique ISO associée présente, dans le point de fonctionnement restreint (308), une pente de courbe caractéristique négative, pour laquelle la vitesse spécifique diminue à mesure qu'augmente l'angle de pale, **caractérisé en ce que** la pente de courbe caractéristique dans le point de fonctionnement restreint (308) diminue avec une valeur qui atteint au moins 0,5/1° en termes de montant.

2. Procédé selon la revendication 1, **caractérisé en ce que**
- le point de fonctionnement de secours (310)
- fonctionne, par rapport au point de fonctionnement normal (302), avec une puissance de sortie moindre, et/ou
- présente, par rapport au point de fonctionnement restreint (308), une vitesse spécifique réduite, et éventuellement
- présente, par rapport au point de fonctionnement normal (302), une vitesse spécifique accrue.

3. Procédé selon la revendication 1 ou 2, **caractérisé en ce que**
- le point de fonctionnement restreint (308) et/ou
- le point de fonctionnement de secours (310)
est sélectionné en fonction de
- un écart de deux courbes caractéristiques Iso pour le point de fonctionnement restreint (308) ou pour le point de fonctionnement de secours (310) et/ou
- un gradient du coefficient de puissance du point de fonctionnement restreint (308) ou du point de fonctionnement de secours (310).

4. Procédé selon l'une quelconque des revendications précédentes, **caractérisé en ce que**
- le point de fonctionnement restreint (308) et/ou le point de fonctionnement de secours (310) sont sélectionnés de sorte que respectivement
- une déduction du coefficient de puissance (Cₚ) du point de fonctionnement restreint (308) ou du point de fonctionnement de secours (310) selon l'angle de pale dépasse une valeur de déduction minimale prédéfinie en termes de montant, en particulier que
- pour le point de fonctionnement restreint (308) la valeur de déduction minimale atteint au moins 0,3/6° (=0,05/1°) et/ou
- pour le point de fonctionnement de secours (310) la valeur de déduction minimale atteint au moins 0,1/6°.

5. Procédé selon l'une quelconque des revendications précédentes, **caractérisé en ce que**
- l'éolienne (100) peut être **caractérisée par** un diagramme caractéristique composé de courbes caractéristiques Iso dans le diagramme λθ, et
- le diagramme caractéristique peut être défini en tant que diagramme caractéristique normalisé dans lequel l'angle de pale est normalisé au degré entier (°),
- dans le diagramme caractéristique normalisé est réalisée une première partie dans laquelle
- les angles de pale sont plus grands que les angles de pale du point de fonctionnement normal, et
- les courbes caractéristiques ISO présentent une pente de courbe caractéristique négative, pour laquelle la vitesse spécifique diminue à mesure qu'augmente l'angle de pale,
- dans le diagramme caractéristique normalisé chaque point de fonctionnement est **caractérisé par** une valeur de gradient qui quantifie la pente maximale du coefficient de puissance du point de fonctionnement dans le diagramme caractéristique normalisé,
- dans lequel, dans la première partie du diagramme caractéristique normalisé, un point de fonctionnement avec une valeur de gradient maximale est présent pour chaque courbe caractéristique Iso et une courbe caractéristique de gradient peut être représentée, qui relie tous ces points de fonctionnement à la valeur de gradient maximale, dans lequel
- le point de fonctionnement restreint (308) et/ou le point de fonctionnement de secours (310) sont sélectionnés de sorte qu'ils se situent respectivement sur la courbe caractéristique de gradient, et/ou
- se situent dans une bande de gradient enfermant la courbe caractéristique de gradient (320), dans lequel
- la bande de gradient
- présente une limite de bande supérieure (321), qui se situe, d'une différence de vitesse spécifique supérieure, au-dessus de la courbe caractéristique de gradient, et
- présente une limite de bande inférieure (322), qui se situe, d'une différence de vitesse spécifique inférieure, au-dessous de la courbe caractéristique de gradient, dans lequel
- les différences de vitesse spécifique supérieure et inférieure présentent de préférence respectivement au maximum la valeur 2, en particulier présentent au maximum la valeur 1, ou
- la différence de vitesse spécifique supérieure présente au maximum la valeur 1 et
- la différence de vitesse spécifique inférieure présente au maximum la valeur 4.

6. Procédé selon l'une quelconque des revendications précédentes,
**caractérisé en ce que** l'éolienne (100)
- dans le point de fonctionnement restreint (308) présente
- une première puissance de sortie,
- une première énergie de rotation et
- un premier angle de pale, et
- dans le point de fonctionnement de secours (310) présente
- une deuxième puissance de sortie,
- une deuxième énergie de rotation et
- un deuxième angle de pale, dans lequel
- la première puissance de sortie est plus petite que la deuxième puissance de sortie et une différence entre la deuxième puissance de sortie et la première puissance de sortie forme une puissance de sortie différentielle des points de fonctionnement,
- la première énergie de rotation (E₁) est plus grande que la deuxième énergie de rotation (E₂), et une différence entre la première et deuxième énergie de rotation forme une énergie de rotation différentielle,
- pour le réglage des pales de rotor à partir du premier angle de pale dans le deuxième angle de pale un temps de réglage de pale est nécessaire,
- un produit de la puissance de sortie différentielle par le temps de réglage de pale multiplié par 50 % forme une énergie différentielle caractéristique (ΔE_{c}), et
- le point de fonctionnement restreint (308) et/ou le point de fonctionnement de secours (310) sont sélectionnés de sorte que l'énergie de rotation différentielle se situe au maximum d'une valeur d'écart en pourcentage prédéfinie au-dessus de ou au-dessous de l'énergie différentielle caractéristique, dans lequel la valeur d'écart en pourcentage atteint au maximum 60 %, de préférence au maximum 40 %, en particulier au maximum 20 %.

7. Procédé selon l'une quelconque des revendications précédentes,
**caractérisé en ce que**
- pour l'ajustement du point de fonctionnement restreint, en particulier à partir du point de fonctionnement normal, un point de fonctionnement intermédiaire est tout d'abord ajusté dans une première étape de réglage, dans lequel
- le point de fonctionnement intermédiaire présente la même valeur Cₚ que le point de fonctionnement restreint, présente au moins une valeur Cₚ modifiée de moins de 20 %, en particulier, que
- dans une deuxième étape de réglage, un passage a lieu à partir du point de fonctionnement intermédiaire dans le point de fonctionnement restreint et le passage peut être représenté dans le diagramme λθ sensiblement en tant que modification le long d'une courbe caractéristique Iso, au moins avec un écart maximal de 20 % de la valeur Cₚ de la courbe caractéristique Iso du point de fonctionnement restreint.

8. Procédé selon l'une quelconque des revendications précédentes,
**caractérisé en ce que**
- la demande de restriction pour demander le fonctionnement de l'éolienne dans le point de fonctionnement restreint est réalisée en tant que consigne externe, qui est reçue par l'intermédiaire d'une interface de données, et/ou
- la demande d'augmentation de puissance pour demander le fonctionnement de l'éolienne dans le point de fonctionnement de secours est réalisée en tant que consigne de réponse à un état du réseau d'alimentation électrique détecté par l'éolienne, en particulier en tant que consigne de mise en œuvre d'une augmentation de puissance à partir du point de fonctionnement restreint (308) en fonction d'une fréquence de réseau détectée du réseau d'alimentation électrique.

9. Procédé selon l'une quelconque des revendications précédentes,
**caractérisé en ce que**
- l'éolienne (100) fonctionne dans le point de fonctionnement restreint (308) pendant un laps de temps plus long que dans le point de fonctionnement de secours (310), en particulier au moins 20 fois plus longtemps.

10. Éolienne (100) avec
- un rotor (106) avec des pales de rotor (108) réglables dans leur angle de pale (θ), dans laquelle le rotor (106) peut fonctionner avec une vitesse de rotation variable, et dans laquelle
- l'éolienne (100) peut fonctionner dans une plage de charge partielle, dans laquelle insuffisamment de vent est présent pour faire fonctionner l'éolienne avec la puissance nominale (P_{N}),
- l'éolienne (100) peut fonctionner dans un point de fonctionnement (302, 308, 310) pouvant être prédéfini de manière variable, et
- le point de fonctionnement (302, 308, 310) est **caractérisé par** l'angle de pale (θ) et une vitesse spécifique (λ), et dans laquelle
- le point de fonctionnement (302, 308,310) peut être représenté dans un diagramme λθ, dans laquelle
- dans le diagramme λθ la vitesse spécifique (X) sur l'angle de pale (θ) est tracée, et
- le point de fonctionnement (302, 308, 310) dans le diagramme λθ peut être représenté en tant que paire de valeurs composée de son angle de pale (θ) et de sa vitesse spécifique (λ), dans laquelle
- un coefficient de puissance (valeur Cₚ) est associé à chaque point de fonctionnement (302, 308, 310), et
- plusieurs points de fonctionnement (302, 308, 310) avec une même valeur Cₚ peuvent être représentés en tant que courbe caractéristique Iso dans le diagramme λθ,
et l'éolienne (100) présente un système de commande (103), préparé à faire fonctionner l'éolienne (100) dans la plage de charge partielle, et ce faisant le prépare
- à faire fonctionner l'éolienne dans un point de fonctionnement normal (302), pour lequel l'éolienne fonctionne de façon non restreinte, lorsqu'aucune demande de restriction n'est présente,
- à faire fonctionner l'éolienne (100) dans un point de fonctionnement restreint (308), pour lequel l'éolienne (100), à la suite d'une demande de restriction, fonctionne avec une puissance de sortie restreinte par rapport au point de fonctionnement normal (302), et
- à faire passer l'éolienne, à partir du point de fonctionnement restreint (308), dans un point de fonctionnement de secours (310), dans lequel l'éolienne, par rapport au point de fonctionnement restreint (308), fonctionne avec une puissance de sortie plus élevée, en réponse à une demande d'augmentation de puissance, dans laquelle
le fonctionnement de l'éolienne (100) est implémenté de telle sorte que
- le point de fonctionnement restreint (308), par rapport au point de fonctionnement de secours (310), présente une vitesse spécifique accrue et
- le point de fonctionnement restreint (308) dans le diagramme λθ se situe sur une courbe caractéristique Iso associée et la courbe caractéristique Iso associée dans le point de fonctionnement restreint (308) présente une pente de courbe caractéristique négative, pour laquelle la vitesse spécifique diminue à mesure qu'augmente l'angle de pale, **caractérisée en ce que**
la pente de courbe caractéristique dans le point de fonctionnement restreint (308) diminue avec une valeur qui atteint au moins 0,5/1° en termes de montant.

11. Éolienne selon la revendication 10,
**caractérisée en ce que** l'éolienne, en particulier le système de commande (103), est préparé(e) à exécuter un procédé selon l'une quelconque des revendications 1 à 9.

12. Éolienne (100) selon la revendication 10 ou 11,
**caractérisée en ce que**
- il est prévu une interface de données, pour recevoir et évaluer un signal externe en tant que consigne externe de la demande de restriction, et
- un système de détection pour détecter et évaluer un état du réseau d'alimentation électrique pour vérifier la présence d'une demande d'augmentation de puissance en tant que consigne de réponse à l'état détecté.

13. Éolienne (100) selon l'une quelconque des revendications 10 à 12,
**caractérisée en ce qu'**une mémoire de commande est prévue et dans la mémoire de commande
- sont enregistrées des consignes de commande pour faire fonctionner l'éolienne selon au moins un procédé selon l'une quelconque des revendications 1 à 9, et/ou
- sont enregistrés des points de fonctionnement dépendant de la vitesse du vent, en particulier sont enregistrés, pour plusieurs vitesses du vent, respectivement un point de fonctionnement normal, un point de fonctionnement restreint et un point de fonctionnement de secours.
